(19) **Europäisches Patentamt / European Patent Office / Office européen des brevets**

(11) **EP 4 447 093 A1**

(12) **EUROPEAN PATENT APPLICATION**
published in accordance with Art. 153(4) EPC

(43) Date of publication:
**16.10.2024 Bulletin 2024/42**

(21) Application number: **22903949.0**

(22) Date of filing: **08.11.2022**

(51) International Patent Classification (IPC):
**H01L 21/304** (2006.01)     **B23K 26/53** (2014.01)

(52) Cooperative Patent Classification (CPC):
**B23K 26/53; H01L 21/304**

(86) International application number:
**PCT/JP2022/041571**

(87) International publication number:
**WO 2023/106018 (15.06.2023 Gazette 2023/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.12.2021 JP 2021199577**
**10.08.2022 JP 2022128100**

(71) Applicant: **DENSO CORPORATION**
**Kariya-city, Aichi 448-8661 (JP)**

(72) Inventors:
• **YASUDA, Koichiro**
**Kariya-city, Aichi 448-8661 (JP)**

• **TAKAGI, Ryota**
**Kariya-city, Aichi 448-8661 (JP)**
• **KAWAZU, Tomoki**
**Kariya-city, Aichi 448-8661 (JP)**
• **NOMURA, Sodai**
**Kariya-city, Aichi 448-8661 (JP)**
• **SHIRAI, Hideaki**
**Kariya-city, Aichi 448-8661 (JP)**
• **SOLTANI, Bahman**
**Kariya-city, Aichi 448-8661 (JP)**
• **SOBAJIMA, Shunsuke**
**Kariya-city, Aichi 448-8661 (JP)**

(74) Representative: **Kuhnen & Wacker**
**Patent- und Rechtsanwaltsbüro PartG mbB**
**Prinz-Ludwig-Straße 40A**
**85354 Freising (DE)**

(54) **WAFER MANUFACTURING METHOD**

(57)     A wafer manufacturing method for obtaining a wafer from an ingot (2) includes the following procedure, steps or processes. A surface (21) of one end side of the ingot in a height direction thereof is irradiated with a laser beam to which the ingot has transparency, thereby forming a peeling layer (25) at a depth position corresponding to a thickness of the wafer from the surface. At this moment, the laser beam is irradiated such that a frequency of irradiation in a facet region (RF) is higher than that in a non-facet region (RN). A wafer precursor (26) as a portion between the surface of the ingot and the peeling layer is peeled from the ingot at the peeling layer. A major surface of a peeling body having a plate like shape, the peeling body being obtained by the wafer peeling step, is planarized electrically, chemically and mechanically, thereby obtaining a wafer.

FIG.4A

EP 4 447 093 A1

# Description

[Cross-Reference of Related Applications]

The present application is based on Japanese Application Nos. 2021-199577 and 2022-128100, filed on December 8, 2021 and August 10, 2022 respectively, the contents of which are incorporated herein by reference.

BACKGROUND

[Technical Field]

The present disclosure relates to a wafer manufacturing method.

[Description of the Related Art]

As a manufacturing method of SiC wafers having relatively low loss of SiC, a method is known in which a laser beam having a wavelength to which SiC has transparency is condensed inside a single crystal ingot to form a modified layer and cracking extended from the modified layer, thereby slicing wafers. According to this method, the focusing point of the laser beam is positioned at a predetermined depth position of the SiC single crystal ingot, causing the laser beam to be scanned along a cut-surface to be cut, thereby forming a modified layer along the cut-surface. For the SiC single crystal, in its growth process, two regions having mutually different growth modes, that is, a region referred to as a facet region and a region referred to as a non-facet region are formed. Transmittances are mutually different between the facet region and the non-facet region. Hence, in the case where a laser beam having a wavelength to which the SiC has transparency is irradiated at a predetermined depth position with respect to the surface of the SiC single crystal ingot so as to form a modified layer, a depth position where an energy density reaches a threshold to form the modified layer is different between the facet region and the non-facet region. In this respect, one literature discloses that an absorbance to the laser beam is different between facet regions and non-facet regions, specifically, the non-facet region has lower absorbance than that of the facet region. This literature also discloses that an intensity of the laser beam which reaches the focusing point in the non-facet region is greater than that of the facet region. Moreover, according to this literature, it is disclosed that a uniform modified layer can be formed at a predetermined depth position of the SiC single crystal ingot when irradiating a laser beam to which SiC has transparency under an appropriate condition for each of the facet region and the non-facet region.

[Citation List]

[Patent Literature]

[PTL1] JP-A-2020-47619

[Summary of the Invention]

As described above, a publicly known literature discloses that the intensity of the laser beam which reaches the focusing point in the non-facet region is greater than that of the facet region, and the laser beam is irradiated under an appropriate condition for each of the facet region and the non-facet region. However, the literature fails to disclose how to control the irradiation condition. On the other hand, PILI discloses a technique in which laser beam energy is increased and the position of the condenser is caused to rise when irradiating the facet region with the laser beam during a processing feed process. The processing feed process refers to the following process. The focusing point of the laser beam having a wavelength to which SiC has transparency is caused to be positioned at a depth position from the upper surface of the SiC ingot corresponding to a wafer thickness to be produced. The SiC ingot and the focusing point are fed relative to each other as a processing feed in the X direction while irradiating a laser beam from the condenser of the laser processing apparatus such that SiC is separated into Si and C forming a belt-shaped peeling layer in which a crack is extended along the c-surface. However, even with this technique, a certain response delay is produced when causing the position of the condenser to rise. Hence, when scanning laser beams at high speed, it is not possible to track the high speed scanning. Further, vibration occurs when moving the condenser in the vertical direction, and therefore a depth position of the modified layer varies, thus causing an increase in wastage. The present disclosure has been achieved in light of the above-exemplified circumstances. That is, according to the present disclosure, a peeling layer is favorably formed for all regions including facet regions and non-facet regions. Therefore, the present disclosure provides a wafer manufacturing method capable of enhancing the manufacturing efficiency compared to conventional technique.

According to one aspect of the present disclosure, a wafer manufacturing method for obtaining a wafer from an ingot includes steps of
a peeling layer forming step that irradiates a surface of one end side of the ingot in a height direction thereof with a laser beam to which the ingot has transparency, thereby forming a peeling layer at a depth position corresponding to a thickness of the wafer from the surface;

a wafer peeling step that peels a wafer precursor as a portion between the surface and the peeling layer from the ingot, the wafer precursor being peeled at the peeling layer; and

a wafer planarization step that planarizes a major surface of a peeling body having a plate like shape, the peeling body being obtained by the wafer peeling step, wherein in the peeling layer forming step, the laser beam is irradiated to the surface such that a frequency of irradiation of the laser beam for the facet region is set to be higher than that for the non-facet region.

According to the wafer manufacturing method, firstly, a peeling layer is formed in the following manner. A surface of one end side of the ingot in a height direction thereof is irradiated with a laser beam to which the ingot has transparency, hereby forming a peeling layer at a depth position corresponding to a thickness of the wafer from the surface. Next, a wafer precursor as a portion between the surface and the peeling layer is peeled from the ingot, the wafer precursor being peeled at the peeling layer. Subsequently, a major surface of a peeling body having a plate-like shape is planarized, the peeling body being obtained by the wafer peeling step, thereby obtaining a wafer.

As described above, the intensity of the laser beam which reaches the focusing point in the non-facet region is greater than that of the facet region. In this respect, when forming the peeling layer, the laser beam is irradiated to the surface such that a frequency of irradiation of the laser beam for the facet region is set to be higher than that for the non-facet region. Specifically, for example, a repetition frequency of the laser beam in the facet region is set to be higher than that of the non-facet region so as to set an irradiation interval in the first direction to be narrower. Alternatively, other than the irradiation of the laser beam for the entire region including the facet region and the non-facet region, the laser beam is caused to be irradiated for the facet region. According to this wafer manufacturing method, the peeling layer can be favorably formed for the entire region including the facet region and the non-facet region. Hence, according to this wafer manufacturing method, manufacturing efficiency can be improved compared to a conventional technique.

Note that reference symbols with parentheses may be applied to respective elements in the respective columns of the specification. In this case, the reference symbols merely indicate relationships between the elements and specific configurations in the embodiments which will be described later. Hence, the present disclosure is not limited thereto even with the reference symbols.

[Brief Description of the Drawings]

[Fig. 1] is a diagram showing a side view of an overall configuration of a wafer, an ingot and a peeled body of a wafer manufacturing method according to an embodiment of the present disclosure.
[Fig.2] is a process chart showing an overall wafer manufacturing method according to an embodiment of the present disclosure.
[Fig.3A] is a diagram showing a side view of an overall configuration of an ingot after a peeling layer forming process shown in Fig.2 is applied.
[Fig.3B] is a plan view showing the ingot indicated by Fig.3A.
[Fig.4A] is a side-view diagram showing a peeling layer forming process indicated by Fig.2 and an overall configuration of a peeling layer forming apparatus used therefor.
[Fig.4B] is a front-view diagram showing a peeling layer forming process indicated by Fig.2 and an overall configuration of a peeling layer forming apparatus used therefor.
[Fig.5A] is a diagram showing an outline of the peeling layer forming process indicated by Fig.4A and Fig.4B.
[Fig.5B] is a diagram showing an outline of the peeling layer forming process indicated by Fig.4A and Fig.4B.
[Fig.6] is a plan view showing an outline of the peeling layer forming process indicated by Fig.4A and Fig.4B.
[Fig.7] is a diagram showing an enlarged view of a laser beam in the vicinity of the focusing point indicated by Fig.4A and Fig.4B.
[Fig.8A] is a side-view diagram showing an outline of the peeling layer forming process indicated by Fig.4A.
[Fig.8B] is a side-view diagram showing an outline of the peeling layer forming process in another example.
[Fig.9] is a side-view diagram showing an outline of the peeling layer forming process indicated by Fig.4A.
[Fig. 10] is a side-view diagram showing an outline of the peeling layer forming process indicated by Fig.4A
[Fig.11] is a side-view diagram showing the wafer peeling process indicated by Fig.2 and an outline of a peeling apparatus used therefor.
[Fig. 12] is a plan view showing a modification example of an arrangement of a plurality of laser beams shown in Fig.5A.
[Fig. 13] is a plan view showing another modification example of an arrangement of a plurality of laser beams shown in Fig.5A.
[Fig. 14] is a process chart showing an outline of a wafer manufacturing method according to a modification example.
[Fig. 15] is a plan view showing an example of a setting for measurement position in a wafer optical measurement shown in Fig. 14.
[Fig. 16] is a plan view showing scanning for the measurement positions in the wafer optical measurement shown in Fig. 14.

[Fig. 17] is a graph showing a change in an absorption coefficient at measurement positions, the absorption coefficient being calculated using a transmittance measured by scanning of the measurement positions.

[Fig. 18A] is diagram showing a side-view cross-section illustrating a difference of the transmittance between positions where the modified layer is generated in a laser slicing process, that is, the peeling layer forming process shown in Fig. 14.

[Fig. 18B] is a diagram showing a side-view cross-section illustrating a difference of the transmittance between positions where the modified layer is generated in a laser slicing process, that is, the peeling layer forming process shown in Fig. 14.

[Fig. 18C] is a diagram showing a side-view cross-section illustrating a difference of the transmittance between positions where the modified layer is generated in a laser slicing process, that is, the peeling layer forming process shown in Fig. 14.

[Fig. 19] is a diagram showing a side-view cross-section illustrating an example of a method of setting an irradiation condition of a laser beam in a laser slicing process, that is, the peeling layer forming process shown in Fig. 14.

[Fig.20] is a diagram showing a plan view for explaining a method for calculating the absorption coefficient indicated by equation (2).

[Fig.21A] is a graph showing a change in the absorption coefficient with respect to a depth direction of the ingot at a center position of the surface shown in Fig.20.

[Fig.21B] is a graph showing a change in the absorption coefficient with respect to the depth direction of the ingot at a first end position shown in Fig.20.

[Fig.21C] is a graph showing a change in the absorption coefficient with respect to the depth direction of the ingot at a second end position shown in Fig.20.

[Fig.22] is a graph showing an example of a method for calculating the absorption coefficient.

[Fig.23] is a diagram showing a side view illustrating a first product and a second product to be produced for setting irradiation conditions of a laser beam in the laser slicing, that is, the peeling layer forming process shown in Fig. 14.

[Fig.24] is a graph showing a change in the absorption coefficient in the case where a measurement pitch is narrowed in a part of region during the wafer optical measurement.

[Description of Embodiments]

(Embodiments)

With reference to drawings, embodiments of the present disclosure will be described. For modifications to be applicable to one embodiment, if the modifications are inserted into a middle of series of explanations of the embodiment, understanding of the embodiment may be hindered. Hence, modification examples are not inserted in the middle of series of explanations of the embodiment, but will be described after the embodiment section.

(Strcuture of wafer and ingot)

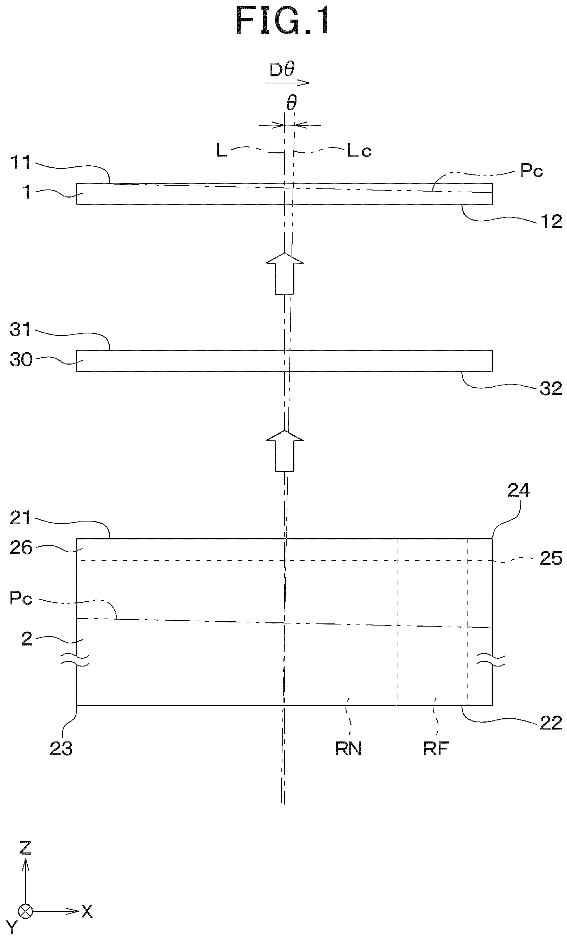

Referring to Fig.1, a wafer 1 produced by a wafer manufacturing method according to the present embodiment is obtained by slicing an ingot 2 having substantially cylindrical shape when viewed in a side view and formed in a thin plate having substantially circular shape when viewed in a plan view. That is, the wafer 1 and the ingot 2 have a substantially columnar side face or end face which surround a center line L. The center axis L is a virtual straight line parallel to the substantially columnar side face or end face of the wafer 1 or the ingot 2, passing through the axial center of the wafer 1 or the ingot 2. In view of simplifying illustration and explanation, illustration and explanation of the so-called orientation flat usually provided at the wafer 1 and the ingot 2 will be omitted.

According to the present embodiment, the ingot 2 is a single crystal SiC ingot having c-axis Lc and (0001) surface Pc which orthogonally cross each other, and an off-angle θ exceeding 0 degree. The c-axis Lc refers to a crystal axis indicated by [0001] as a direction index. Note that the (0001) surface Pc refers to a crystal surface which orthogonally crosses the c-axis Lc, referred to as C-surface in strict meaning in crystallography. The off-angle θ is an angle formed between the center axis L of the wafer 1 or the ingot 2 and the c-axis Lc, for example, 1 to 4 degrees. In other words, the c-axis Lc in the wafer 1 and the ingot 2 is in a state where the center axis L is inclined by the off-angle θ which exceeds 0 degree with respect to the off-angle direction Dθ. The off-angle direction Dθ is a direction with which a moving direction of points on the center axis L in a laser irradiation surface (i.e. upper surface or top surface in Fig.1) is projected on the laser irradiation surface, when the center axis L is caused to rotate towards the c-axis Lc with respect to a cross-point between the center axis L and the c-axis Lc as the center thereof.

In order to simplify explanation, a right-handed XYZ coordinate system is defined as shown in Fig.1. In the right-handed XYZ coordinate, it is assumed that the off-angle direction Dθ and the X-axis positive direction are the same direction. Further, the X-axis and the Y-axis are assumed to be parallel to major surfaces of the wafer 1 and the ingot 2. A major surface is a surface orthogonal to a thickness direction of a plate object and also referred to as an upper surface, a bottom surface or plate surface. Moreover, a major surface is a surface orthogonal to a height direction of a columnar object such as an ingot 2 and also referred to as a top surface or a bottom surface. Further, the thickness direction of the wafer 1 and the height direction of the ingot 2 are assumed to be parallel to the Z- axis. Hereinafter, any directions orthogonal to the Z-axis are sometimes referred to as in-plane directions.

The wafer 1 has a wafer C-surface 11 and a wafer Si surface 12 as a pair of major surfaces. According to the present embodiment, the wafer 1 is formed such that the wafer C-surface 11 as an upper surface is inclined by the off-angle θ with respect to (0001) surface Pc. Similarly, the ingot 2 has an ingot C-surface 21 and an ingot Si surface 22 as a pair of major surfaces. The ingot 2 is formed such that the ingot C-surface 21 as the top surface is inclined by the off-angle θ with respect to (0001) surface Pc. Hereinafter, one end of the ingot 2 in the off-angle direction Dθ, that is, an upstream end, is referred to as a first end 23, and the other end, that is, a downstream end, is referred to as a second end 24. In Fig. 1, the direction along which the wafer C-surface 11 and the ingot C-surface 21 are oriented is indicated as a Z-axis positive direction.

Further, the ingot 2 has facet regions RF. The facet regions RF are also referred to as facet parts. Parts other than facet regions RF in the ingot 2 are referred to as non-facet regions RN. Similarly, non-facet regions RN are also referred to as non-facet parts.

(Outline of wafer manufacturing method)

A wafer manufacturing method according to the present embodiment is to obtain the wafer 1 from the ingot 2 and includes the following processes.

(1) Peeling layer forming process: an ingot C-surface 21 as a major surface at one end side of the ingot 2 with respect to the height direction thereof is irradiated with a laser beam to which the ingot 2 has transparency, thereby forming a peeling layer 25 at a depth corresponding to a thickness of the wafer 1 with respect to the ingot C-surface 21. Here, prescribed permeability is a permeability capable of forming a focus point of the laser beam at a portion of a depth corresponding to a thickness of the wafer 1 in the ingot 2. Also, a depth corresponding to a thickness of the wafer 1 refers to a dimension in which a thickness corresponding to a predetermined processing margin in a wafer planarization process (described later) is added to a thickness of a wafer 1 as a completed product (i.e. target value of the thickness), and also referred to as a depth equivalent to the thickness of the wafer 1.

(2) Wafer peeling process: a wafer precursor 26 which is a portion between the ingot C-surface 21 as a laser irradiation surface and the peeling layer 25 is peeled from the ingot 2 at the peeling layer 25. Here, like the above-described wafer peeling process, a plate-like object obtained by peeling the wafer precursor 26 from the ingot 2 may be referred to as a wafer in commonly-accepted terms. However, in order to differentiate the plate-like object from the wafer 1 having a major surface which is an epi-ready mirror surface as a completed product after the manufacturing, the plate-like object is referred to as a peeled body 30 in the following description. The peeled body 30 has a non-peeling surface 31 and a peeling surface 32 as a pair of major surfaces. The non-peeling surface 31 is a surface in which no peeling layer 25 is formed before the wafer peeling process. The non-peeling surface 31 corresponds to the ingot C-surface 21 before performing the peeling layer forming process and the wafer peeling process. The peeling surface 32 constitutes the peeling layer 25 before the wafer peeling process, serving as a surface newly generated by the wafer peeling process. The peeling surface 32 is a rough uneven surface due to the peeling layer 25 and peeling by the wafer peeling process, which requires grinding or polishing.

(3) Wafer planarization process: at least peeling layer 32 among the non-peeling surface 31 and the peeling surface 32 as major surfaces of the peeled body 30 is planarized, thereby obtaining the wafer 1 as a final good product after the manufacturing process. According to the wafer planarization process, ECMG or ECMP can be utilized in addition to general wheel-polishing or CMP. Note that CMP is an abbreviation of chemical mechanical polishing, ECMG is an abbreviation of electro-chemical mechanical grinding, and ECMP is an abbreviation of electro-chemical mechanical polishing. The wafer planarization process may be performed using one process in these planarization processes or any of these processes may be appropriately combined.

(4) Ingot planarization process: After peeling the wafer precursor 26, the newly generated upper surface of the ingot 2 is planarized, that is, a mirrored surface is produced such that the planarized upper surface can be provided again for the peeling layer forming process. Also in the ingot planarized process, ECMG or ECMP can be utilized in addition to general wheel-polishing or CMP. Also, the ingot planarization process may be performed using one process in these planarization processes or any of these processes may be appropriately combined.

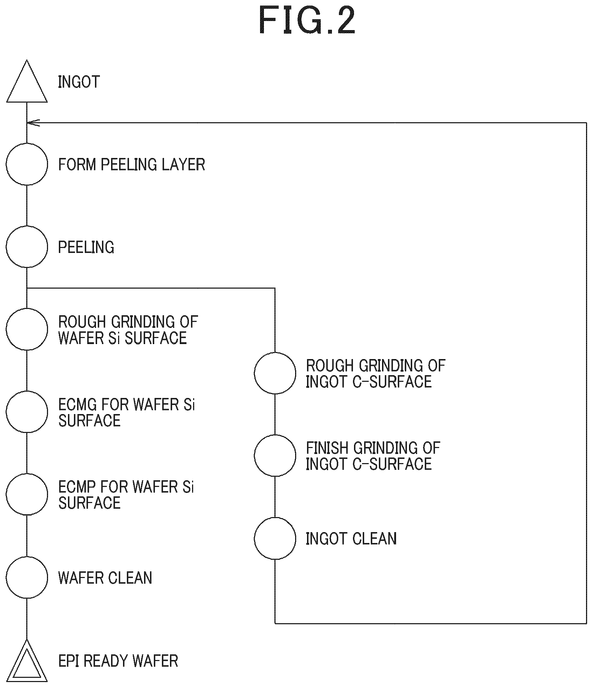

Fig.2 is a process chart showing a typical example of embodied wafer manufacturing method according to the present embodiment. As shown in Fig.2, the peeled body 30 peeled from the ingot 2 via the peeling layer forming process and the wafer peeling process is finished to produce an epi-ready wafer 1 through the following processes.

- rough grinding of the peeling surface 32 which will be the wafer Si surface 12
- ECMG grinding of the peeling surface 32 after applying rough grinding

- ECMP polishing of the peeling surface 32 after applying ECMG grinding
- cleaning

Further, the ingot 2 remaining after peeling the peeled body 30 from the ingot 2 through the peeling layer forming process and the wafer peeling process can be supplied to the peeling layer forming process again through the following processes.

- rough grinding of the ingot C-surface 21 which was newly generated by the wafer peeling process
- finish grinding of the ingot C-surface 21 after rough grinding
- cleaning

Hereinafter, respective processes will be detailed with reference to other figures in addition to Figs. 1 and 2.

(Peeling layer forming process)

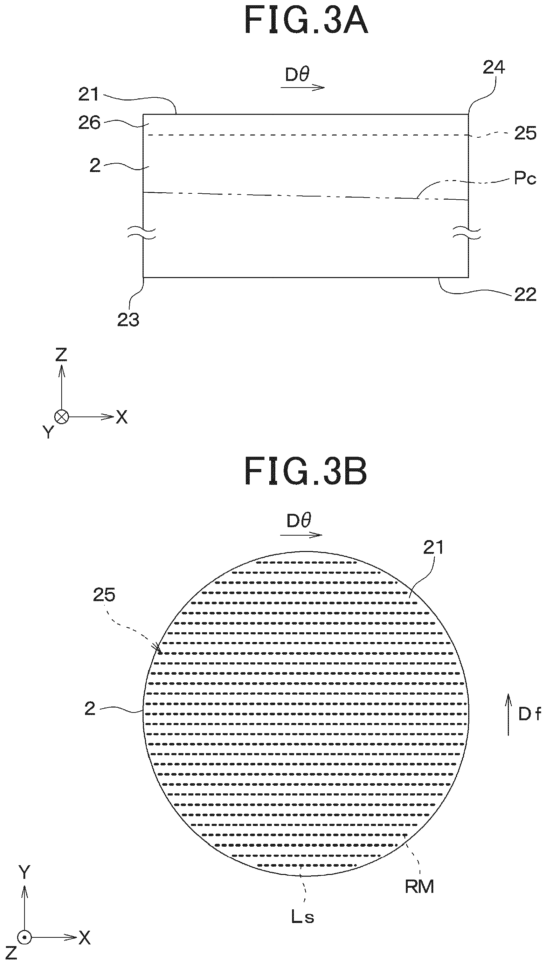

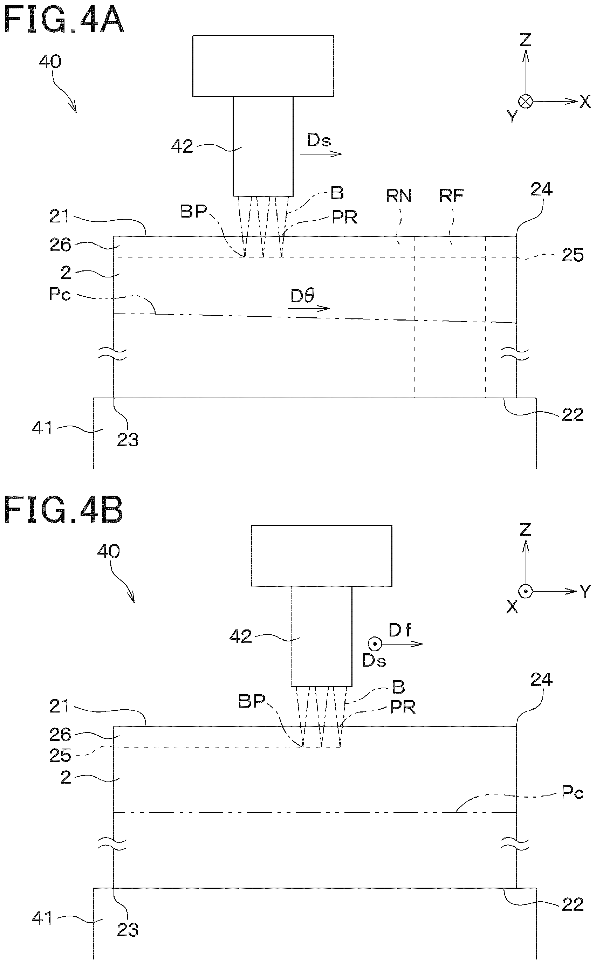

Fig.3A and Fig.3B illustrates an overall configuration of the ingot 2 in a state where the peeling layer 25 and the wafer precursor 26 are formed by the peeling layer forming process. Fig.4A and Fig.4B illustrate an outline of the peeling layer forming process and an overall configuration of a peeling layer forming apparatus 40 used therefor. Note that the right-handed XYZ coordinate system shown in Fig.3A and Fig.4B is indicated conforming to the right-handed XYZ coordinate system shown in Fig. 1.

Referring to Fig.3A and Fig.3B, a plurality of scanning lines Ls are formed as irradiation marks of the laser beam, having a linear shape along the X axis, thereby forming the peeling layer 25. The scanning lines Ls are formed in which an irradiation mark RM of the laser beam on the ingot 2 is linearly formed. According to the present embodiment, the scanning lines Ls are provided along the off-angle direction Dθ. Then, a plurality of scanning lines Ls are arranged in a line feed direction Df. The line feed direction Df refers to an in-plane direction orthogonal to the off-angle direction Dθ. That is, the line feed direction Df refers to a direction orthogonal to the off-angle direction Dθ and orthogonal to the height direction of the ingot 2.

Referring to Fig.4A and Fig.4B, the peeling layer forming apparatus 40 is provided with a chuck table 41 and a beam condensing apparatus 42. The chuck table 41 holds the ingot 2 in an ingot Si surface 22 side, that is, its bottom surface side. Specifically, for example, the chuck table 41 is provided with a suction mechanism that suctions the ingot Si surface 22 using air pressure or the like. Note that a fixing method for fixing the ingot 2 on the chuck table 41 is not limited to the above method. The beam condensing apparatus 42 is disposed opposing the chuck table 41 in a beam axis direction as an irradiation direction of the laser beam B so as to irradiate the ingot 2 as a processing object fixed on the chuck table 41 with the laser beam B transmitted by the pulse laser oscillator (not shown). In other words, the beam condensing apparatus 42 is provided so as to irradiate the ingot 2 from an ingot C-surface 21 side (upper surface side of the ingot 2) with the laser beam B. Specifically, the beam condensing apparatus 42 is configured to form a beam focus point BP of the laser beam inside the ingot 2 at a portion of a depth corresponding to the thickness of the wafer 1 from the ingot C-surface 21. The beam condensing apparatus 42 is referred to as a condenser provided with an optical element (e.g. lens) that forms the beam focus point BP of the laser beam at a predetermined position. The peeling layer forming apparatus 40 is configured to be capable of relatively moving the beam focus point BP at least in the in-plane direction, that is, XY-direction, with respect to the ingot 2. Here, the in-plane direction is parallel to the ingot C-surface 21 as the upper surface of the ingot 2.

The peeling layer forming apparatus 40 forms the scanning line Ls along the scanning direction Ds using laser scanning that scans the ingot C-surface 21 in the scanning direction Ds (i.e. first direction) with the laser beam B. In other words, in laser scanning, the laser beam B is caused to irradiate the ingot C-surface 21 while moving an irradiation position PR of the laser beam B in the scanning direction Ds on the ingot C-surface 21 as the laser irradiation surface. According to the present embodiment, the scanning direction Ds is a direction along the off-angle direction Dθ, specifically, a direction which is the same as the off-angle direction Dθ or opposite to the off-angle direction Dθ. The peeling layer forming apparatus 40 performs the laser scanning a plurality of times while changing the position in the line feed direction Df (i.e. second direction) to form a plurality of scanning lines Ls along the line feed direction Df, thereby forming the peeling layer 25. The line feed direction Df and the scanning direction Ds are the in-plane direction, and orthogonally crossing each other.

According to the present embodiment, the peeling layer forming apparatus 40 causes the chuck table 41 on which the ingot 2 is placed to relatively move with respect to the beam condensing apparatus 42 in the scanning direction Ds to scan the ingot C-surface 21, thereby forming the scanning line Ls in the scanning direction Ds. Also, the peeling layer forming apparatus 40 causes, after executing one laser scanning, the chuck table 41 to relatively move with respect to the beam condensing apparatus 42 along the line feed direction Df by a predetermined amount. Then, the peeling layer forming apparatus 40 again causes the chuck table 41 to relatively move with respect to the beam condensing apparatus 42 along the scanning direction Ds (i.e. a direction same as or opposite to the direction when performing the laser scanning) and scans the laser beam B, thereby forming the scanning line Ls. Thus, the peeling layer forming apparatus 40 scans the laser beam B for almost entire width in the line feed direction Df, whereby a plurality of scanning lines Ls are formed along the line feed direction Df. Moreover, a wafer precursor 26 which will be the wafer 1 is formed in a portion closer to the ingot C surface 21 side than a portion where the peeling layer 25 is positioned. As described above, according to the present embodiment, the chuck table 41 that holds the ingot 2 is provided to be capable of moving in the in-plane direction by a scanning unit such as an electrical stage unit (not shown) while the beam condensing apparatus 42 is provided at a fixed position with respect to the in-plane direction. On the other hand, as described later, the present disclosure is not limited to the above-described configuration. That is, a configuration may be utilized in which the beam condensing apparatus 42 is provided to be capable of moving in the in-plane direction by a scanning unit (not shown) while the chuck table 41 that holds the ingot 2 is provided at a fixed position with respect to the in-plane direction. However, according to any one of these configurations, seemingly, the laser beam B and its irradiation position PR move on the major surface in the in-plane direction, or the laser beam B and its beam focus point BP move inside the ingot 2 in the in-plane direction. Therefore, in order to simplify the explanation, hereinafter, it is described that the laser beam B and its irradiation point PR move on the ingot 2 in the in-plane direction, and the laser beam B and its beam focus point BP move inside the ingot 2 in the in-plane direction. However, as described later, the present disclosure is not limited to the above-described configurations.

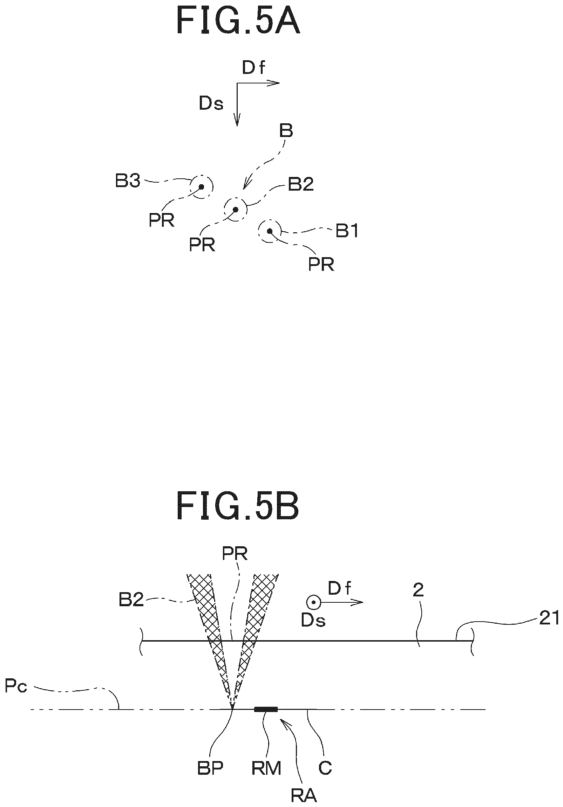

According to the present embodiment, as shown in Fig.4A and Fig.4B, with a single laser scanning, a plurality of laser beams B of which the irradiation positions PR are different in the scanning direction Ds and the line feed direction Df are irradiated on the ingot C-surface 21. Specifically, as shown in Fig.5A and Fig.5B, a plurality of laser beams B (i.e. first beam B1) moves in the scanning direction Ds. The plurality of laser beams B are arranged such that the irradiation positions PR on the ingot C-surface 21 are inclined with respect to both the scanning direction Ds and the line feed direction Df in plan view. Thus, with a single laser scanning, a plurality of scanning lines Ls are formed. Hence, with one laser scanning, a plurality of scanning line Ls are formed. Hence, a cycle time of the peeling layer forming process can be favorably reduced.

In Figs.4A, 4B and 5A, as the plurality of laser beams B, three laser beams B are exemplified. This is due to simplification of illustration and the number of laser beams B is not limited. However, in order to simplify the explanation, hereinafter, as the plurality of laser beams B, at least the first beam B1, the second beam B2 and the third beam B3 are included. In the first beam B1, the second beam B2 and the third beam B3, the first beam B1 is positioned at the most preceding position, that is, the side furthermost in the scanning direction Ds. On the other hand, the third beam B3 is at the most rearward position. Then, the second beam B2 is positioned between the first beam B1 and the third beam B3 with respect the scanning direction Ds and the line feed direction Df.

As shown in Fig.5A, the first beam B1 precedes the second beam B2 and proceeds in the scanning direction Ds. With an irradiation of the first beam B1, as shown in Fig.5B, an irradiation influenced region RA is generated at a predetermined depth position from the ingot C-surfaec 21 as the laser irradiation surface. The irradiation influenced region RA includes an irradiation mark RM composed of a modified region formed when SiC is separated into Si and C by the irradiation of the laser beam B, and cracking C extending from the irradiation mark RM to a portion therearound along (0001) surface Pc. Hence, the irradiation point PR of the second beam B2 may be overlapped, in the irradiation influenced region RA formed by the preceded first beam B1, with at least cracking C in the in-plane direction. When the irradiation mark RM or cracking C included in the irradiation influenced region RA formed by the preceding first beam B1 occurs in the irradiation point PR in the rearward position, with the irradiation influenced region RA, an absorption ratio of the second beam increases. Therefore, the irradiation mark RM is likely to be formed by the second beam B2 in the rearward position, at a depth position which is the same as the depth position of the irradiation influenced region RA formed by the preceded first beam B1. The same applies to the relationship between the second beam B2 and the third beam B3. Thus, adjacent three irradiation marks RM in the line feed direction Df or the irradiation influenced region RA which are formed by the first beam B1 to the third beam B3 with one laser scanning are likely to be formed at the same depth position. That is, a plurality of scanning lines Ls adjacently positioned in the line feed direction Df constituting the peeling layer 35 are likely to be formed at substantially the same depth position.

Thus, according to the present embodiment, variation of the depth of irradiation mark RM, that is, the scanning lines Ls constituting the peeling layer 25 can be suppressed as much as possible. Thus, the degree of steps or uneven portions at the peeling layer generated by a peeling in the peeling layer 25 are favorably suppressed, a processing margin of grinding or polishing on the peeling surface 32 is reduced and peeling faults are favorably suppressed. Further, a cycle time for forming the peeling layer 25 can be reduced. Therefore, according to the present embodiment, manufacturing efficiency can be improved compared to a conventional technique.

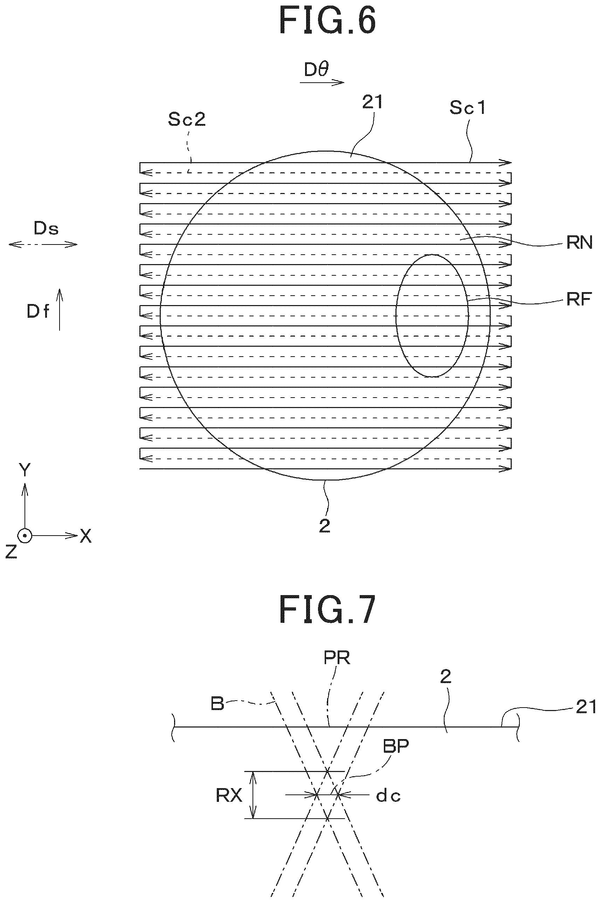

Fig.6 shows a trajectory of the center position in the in-plane direction of the beam condensing apparatus 42 which relatively moves with respect to the ingot 2. Note that 'the center position in the in-plane direction of the beam condensing apparatus 42' refers to, for example, a center position in an arrangement of a plurality of laser beams B. As shown in Fig.4A and Fig.6, according to the present embodiment, a posture of the ingot 2 is set such that the facet region RF is positioned in a lower off-angle side, and the laser beam B is irradiated from the C-surface side, thereby performing a peeling layer forming process. Note that 'lower off-angle side' refers to a lower inclination side on the C-surface, that is, (0001) surface Pc in the case where the posture of the ingot 2 is set such that the ingot C-surface 21 as one major surface is the upper surface. In contrast, 'higher off-angle side' refers to a higher inclination side on the C-surface that is, (0001) surface Pc in the case where the posture of the ingot 2 is set such that the ingot C-surface 21 is the upper surface.

As will be described later, a uni-directional load is applied to one end in the higher off-angle side of the ingot 2 to peel the wafer precursor 26 from the ingot, whereby favorable wafer peeling can be achieved. A case will be assumed in which the posture of the ingot 2 is set such that the facet region RF is positioned to be in the higher off-angle side and the laser beam B is irradiated from the Si surface side, and thereafter, a unidirectional load is applied at one end of the higher off-angle side in the ingot 2. In this respect, an end portion positioned closer to the facet region RF in the ingot 2 is unlikely to be cracked. Hence, according to the above-described case, since a peeling start position is an end portion closely positioned to the facet region RF which is unlikely to be cracked, a success rate of the wafer peeling process may be lowered. However, according to the present embodiment, the posture of the ingot 2 is set such that the facet region RF is positioned at a lower off-angle side, and the laser beam B is irradiated from the C-surface side, thereafter, a unidirectional load is applied to the one end of the higher off-angle side in the ingot 2. In this case, the peeling start position is a portion away from the facet region RF. Therefore, according to the present embodiment, the success rate for the wafer peeling process is improved.

It is known that the intensity of the laser beam B that arrives at the beam condensing point BP for the non-facet region RN is higher than that of the facet-region RF. For this reason, according to the present embodiment, in the peeling layer forming process, the laser beam B is caused to be irradiated on the major surface of the ingot 2 such that an energy application density of the irradiation of the laser beam B for the facet region RF is higher than that for the non-facet region RN. Here, 'energy application density' refers to an application density of energy on the surface along the major surface of the ingot 2. The followings means may be utilized as a single means or a combined means in which a plurality of following means are combined. Specifically, for example, an amount of output of the laser beam B for the facet region RF may be set to be higher than that for the non-facet region RN. Alternatively, for example, the laser beam B may be caused to be irradiated on the major surface of the ingot 2 such that a frequency of irradiation of the laser beam B for the facet region RF is set to be higher than that for the non-facet region RN. More specifically, for example, a repetition frequency of the laser beam B for the facet region RF may be set to be higher than that for the non-facet region RN, or the scanning speed be set to be lowered with a constant respective frequency to set an irradiation interval in the scanning direction Ds to be narrower. When setting an amount of the output of the laser beam B for the facet region RF to be higher than that for the non-facet region EN, the amount of the output for the facet region RF may preferably be 1.5 times of that for the non-facet region RN. When setting the irradiation interval in the scanning direction Ds or the line feed direction Df for the facet region RF to be narrower than that for the non-facet region RN, the irradiation interval for the facet region RF may preferably be 2/5 of the irradiation interval for the non-facet region RN. Alternatively, for example, other than the irradiation of the laser beam B for the entire region including the facet region RF and the non-facet region RN, the laser beam B is caused to be irradiated for the facet region RF. Note that, when causing the laser beam B to irradiate the facet region RF, the laser beam B is irradiated for a region close to the facet region RF in the non-facet region RN.

According to the peeling layer forming process of the present embodiment, the peeling layer 25 can be favorably formed for the entire region including the facet region RF and the non-facet region RN. In particular, without using a distance adjustment in the Z-axis direction between the beam condensing apparatus 42 in a radiation side of the laser beam B and the chuck table 41 that holds the ingot 2, the peeling layer 25 can be formed for the facet region RF similar to the non-facet region RN. Therefore, according to the present embodiment, manufacturing efficiency can be improved compared to a conventional technique.

Referring to Figs.4A and 6, in the peeling layer forming process, forward scanning Sc1 and backward scanning Sc2 are performed. For the forward scanning Sc1, the irradiation position PR when irradiating the laser beam B moves on the maj or surface of the ingot 2 in the same direction as the off-angle direction $D\theta$. For the backward scanning Sc2, the irradiation position PR when irradiating the laser beam B moves on the major surface of the ingot 2 in a direction opposite to the off-angle direction $D\theta$. In other words, in the forward scanning Sc1, the scanning direction Ds is the same as the off-angle direction $D\theta$. In the backward direction Sc2, the scanning direction Ds is a direction opposite to the off-angle direction $D\theta$. The forward scanning Sc1 and the backwards scanning Sc2 are alternately performed.

In a period from when one forward scanning Sc1 is completed to when the next backward scanning Sc1 starts, a relative position of the beam condensing apparatus 42 relative to the ingot 2 moves in the line feed direction Df by a predetermined amount. However, in a period from when one forward scanning Sc1 is completed to when the backward scanning Sc2 to be performed immediately after completing the one forward scanning Sc1 is started, the relative position of the beam condensing apparatus 42 in the line feed direction Df may be moved or may not be moved. The same applies to the case of a period from when completing one backward scanning Sc2 to when starting subsequent forward scanning Sc1. For an amount of relative movement in the line feed direction Df is appropriately set depending on a irradiation condition or the like of the laser beam B.

In the forward scanning Sc1, the laser beam B is irradiated over the entire width region of the ingot 2 in the scanning direction Ds. That is, in the forwards scanning Sc1, the laser beam B is caused to be irradiated on the maj or surface of the ingot 2 while moving the irradiation position PR on the maj or surface of the ingot 2 in the scanning direction Ds which is the same as the off-angle direction. Thus, the scanning line Ls is formed between both ends of the ingot 2 in the scanning direction Ds. In contrast, in the backward scanning Sc2, the laser beam B may be irradiated for the entire width region of the ingot 2 in the scanning direction Ds, or may not be irradiated for the entire width region of the ingot 2 in the scanning direction Ds. Alternatively, in the backward scanning Sc2, the laser beam B may be irradiated for a part of width region of the ingot 2 in the scanning direction Ds, not for the entire width region of the ingot 2 in the scanning direction Ds.

Specifically, for example, in the backward scanning SC2, the laser beam B may be irradiated for the facet region RF and its peripheral region. Thus, the peeling layer 25 may be favorably formed for the entire region including the facet region RF and the non-facet region RN. Alternatively, for example, in the backward scanning Sc2, the laser beam B may be irradiated only for an end portion of the ingot 2 in the scanning direction Ds. In this case, in the backward scanning Sc2, the scanning line Ls is formed at the end portion of the ingot 2 in the scanning direction Ds. In this case, in the backward scanning Sc2, the scanning line Ls is formed at the end portion of the ingot 2 in the scanning direction Ds while moving the irradiation position PR on the major surface of the ingot 2 in the scanning direction Ds opposite to the off-angle direction Dθ. Thus, start of peeling can be favorably accelerated in the wafer peeling process and a success rate of the wafer peeling process is improved. Also, in the backward scanning SC2, the laser beam B may be irradiated for the facet region RF, its peripheral region and the end portion of the ingot 2 in the scanning direction Ds.

As shown in Fig.7, according to the present embodiment, the laser beam B has an intensity distribution in which the intensity becomes higher at an outer edge part positioned in a further outer side than the center portion in a beam diameter direction as a direction radially extending from its axial center. Specifically, the laser beam B has a beam shape in which the beam is focused into a dot shape at the focus point BP while having an annular shape, that is, a shape having a hollow near the focus point BP. The laser beam B has a focusing diameter dc as a minimum beam diameter at the focus point BP.

The crossing range RX shown in Fig.7 refers to a predetermined range with respect to the beam axis direction, surrounding the focus point BP as the center thereof. In the predetermined range, the outer edge parts having higher intensities are overlapped.

Thus, the peeling layer forming apparatus 40 irradiates the annular laser beam B on the ingot 2. Note that apparatuses for generating such an annular laser beam B and irradiating the laser beam B to an object to be processed are well known or publicly known at the time of filing of the present disclosure (e.g. JP-A-2006-130691, JP-A-2014-147946). Hence, detailed description of an apparatus or a method of generating the laser beam B will be omitted in this specification.

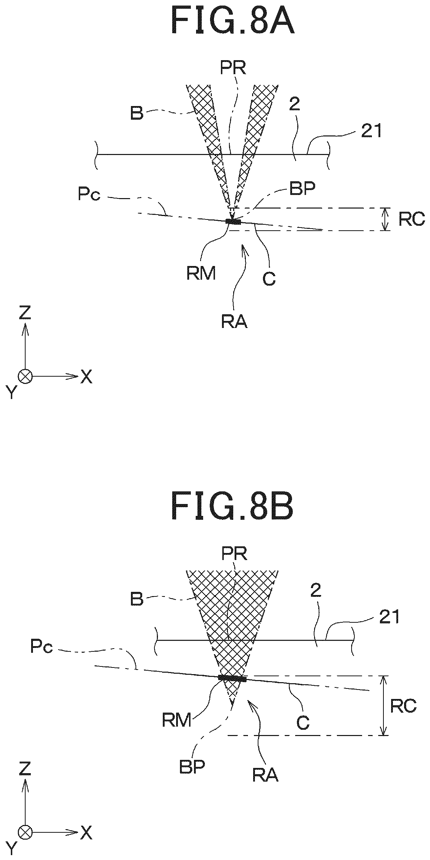

Fig.8A shows a state where an irradiation influenced region RA including the irradiation mark RM is formed by the annular laser beam B according to the present embodiment. Fig.8B shows, as another example different from the present disclosure, a state where an irradiation influenced region RA including the irradiation mark RM is formed by a non-annular laser beam B, that is, a non-hollow (solid) laser beam B.

As shown in Fig.8B, when using a solid laser beam B, the irradiation mark RM, as a modified region which is formed when SiC is separated into Si and C by irradiation of the laser beam B, may be formed at a depth portion different from that of the focus point BP. Hence, depth of the irradiation influenced region RA configured of the irradiation mark RM and cracking C extended from the irradiation mark RM may be different from the depth of the focus point BP. Specifically, for example, an energy application density of irradiation of the laser beam B may become an extent that an irradiation mark RM is produced, at a depth position shallower than the focus point BP. Then, the irradiation mark RM may be produced at a shallower position than the focus point BP. The depth position at which the irradiation mark RM is produced varies depending on a variation of the irradiation energy of the laser beam B or a variation of the refractive index of the ingot 2 or a variation of an optical system in the beam condensing apparatus 42. Note that a region where the irradiation mark RM may possibly be produced is shown as a possible modified region RC. The irradiation mark RM corresponds to 'modified layer' in PTL1.

As shown in Fig.8A, in the case where the annular laser beam B is used, the depth position at which the energy application density of the laser beam B becomes an extent that an irradiation mark RM is produced, is limited to a depth position close to the focus point BP. In other words, for example, similar to the case where a solid laser beam B is used, it is difficult to cause the energy application density with an irradiation of the laser beam B, to become an extent that the irradiation mark RM is produced at a shallower depth position than the focus point BP. Hence, the irradiation mark RM is stably produced at a depth position close to the focus point BP. That is, the possible modified region RC is limited to a narrower depth range with respect to the focus point BP as the center of the range. This is different from a case where the solid laser beam B is used. Therefore, a variation of a depth position where the irradiation mark RM is produced can be favorably suppressed. In other words, the peeling layer 25 can be formed to be thinner as much as possible and a processing margin for grinding or polishing after peeling can be favorably reduced. Hence, according to the present embodiment, manufacturing efficiency can be improved compared to a conventional technique.

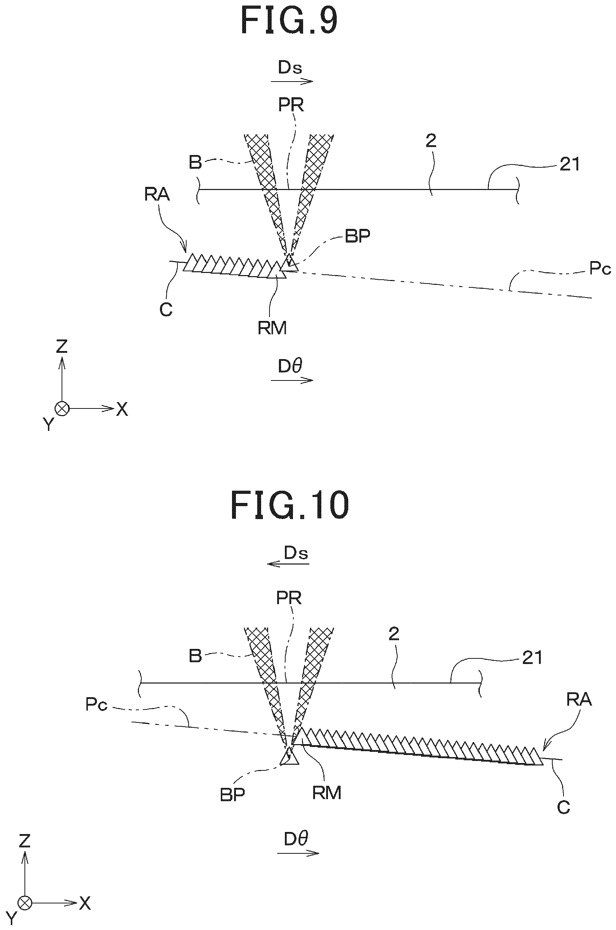

According to a method disclosed by PTL1, the laser scanning direction is a direction orthogonal to a direction with which the off-angle θ is formed (i.e. off-angle direction Dθ shown in Figs. 1 and 3A). Hence, cleavage is not stable and causes an increase in material wastage. In this respect, according to the present embodiment, as shown in Fig.4A, the scanning direction Ds as a moving direction of the focus point BP of the laser beam inside the ingot 2 is parallel to the off-angle direction Dθ. That is, in the peeling layer forming process, with the laser scanning, the irradiation position PR is moved in the scanning direction Ds along the off-angle direction Dθ. In other words, the peeling layer forming apparatus 40 causes the beam condensing apparatus 42 to move relatively to the ingot 2 in the scanning direction Ds parallel to the off-angle direction Dθ, thereby forming the scanning line Ls along the off-angle direction Dθ. Then, as shown in Figs.9 and 10, the irradiation mark RM and cracking C are formed along (0001) surface Pc. Thus, cleavage in the peeling layer 25 during the wafer peeling process can be stabilized, and material wastage can be effectively reduced. Further, a processing margin in the wafer planarization process is favorably reduced and the processing time can be shortened as much as possible. Therefore, according to the present embodiment, a wafer manufacturing method is provided in which a higher manufacturing efficiency is achieved compared to a conventional technique.

Fig.9 shows an example where the scanning direction Ds is the same as the off-angle direction Dθ. Fig. 10 shows an example where the scanning direction Ds is opposite to the off-angle direction Dθ. That is, according to the example shown in Fig.9, in the case where the posture of the ingot 2 is set such that the ingot C-surface 21 is the upper surface thereof as shown in Fig.4A, with the laser scanning, the irradiation position PR is caused to move from a higher side to a lower side on the (0001) surface Pc. According to the example shown in Fig. 10, in the case where the posture of the ingot 2 is set such that the ingot C-surface 21 is the upper surface thereof, with the laser scanning, the irradiation position PR is caused to move from the lower side to the higher side on the (0001) surface Pc.

For example, it is assumed that there is no irradiation influenced region RA, that is, no irradiation mark RM and no crack C are present, in the vicinity of the irradiation position PR in the in-plane direction.

In this situation, the irradiation mark RM is likely to be produced by irradiation of the laser beam B at a depth position close to the focus point BP. On the other hand, actually, the laser beam B moves in the scanning direction DDs while subsequently generating the irradiation marks RM and cracking C. Hence, the above-described situation is produced mainly when the irradiation mark RM corresponding to the start point of the scanning line Ls is formed, which is initially formed in the first laser scanning. Hence, in almost all laser scanning operations, the irradiation influenced region RA is present in the vicinity of the irradiation position PR in the in-plane direction.

As shown in Figs.9 and 10, an irradiation influenced region RA formed previously (e.g. just before) is present at the current irradiation position PR. Then, in the irradiation influenced region RA, an absorption ratio of the laser beam B increases. Further, the irradiation influenced region RA is formed along the (0001) surface Pc. Hence, with the laser scanning, the irradiation mark RM is likely to be extended along the (0001) surface Pc.

Here, according to the example shown in Fig.8, with the laser scanning, the irradiation mark RM is subsequently formed to be at deeper depth positions when the laser scanning proceeds in the scanning direction Ds along the (0001) surface Pc, thereby being apart from the focus point BP. With this irradiation mark formation, at a depth position substantially the same as that of the irradiation mark RM formed just before the current scanning, the energy application density by the laser beam B to be currently irradiated may not be enforced to an extent that new irradiation mark RM is produced. In this case, the irradiation mark RM no longer extends along the (0001) surface Pc. Then, as shown in Fig.9, an irradiation mark RM is newly formed at a depth position in the vicinity of the focus point BP of the laser beam currently irradiated. Specifically, a step is formed between an irradiation mark RM formed just before the current scanning and a currently-formed irradiation mark RM.

On the other hand, in an example shown in Fig. 10, with the laser scanning, the irradiation mark RM is subsequently formed to be at shallower depth positions when the laser scanning proceeds in the scanning direction Ds along the (0001) surface Pc, thereby being apart from the focus point BP. With this irradiation mark forming, at a depth position substantially the same as that of an irradiation mark RM formed just before, the energy application density by the laser beam B to be currently irradiated is not maintained to an extent that new irradiation mark RM is produced, and the irradiation mark RM no longer extends along the (0001) surface Pc. Then, as shown in Fig. 10, an irradiation mark RM is newly formed at a depth position in the vicinity of the focus point BP of the laser beam currently irradiated. However, in an example shown in Fig. 10, since it is different from the example shown in Fig.9, a direction along which the irradiation mark RM extends is a direction closer to a light source side of the laser beam B, that is, a laser irradiation surface side of the ingot 2. Hence, in the example shown in Fig.10, the irradiation mark RM is likely to extend longer than that of the example shown in Fig.9. Therefore, in the example shown in Fig.10, compared to the example shown in Fig, 10, a step formed between the irradiation mark RM formed just before current scanning and the currently formed irradiation mark RM becomes larger.

Thus, the irradiation position PR in the laser scanning is caused to be moved from a higher side to the lower side of the C surface, setting the scanning direction Ds to be the same as the off-angle direction $D\theta$, whereby the step formed between the irradiation mark RM formed just before current scanning and the currently formed irradiation mark RM can be smaller. Thus, the peeling layer 25 can be formed to be as thin as possible, and a processing margin of grinding or polishing after the peeling can be favorably reduced. Hence, according to the present embodiment, manufacturing efficiency can be improved compared to a conventional technique.

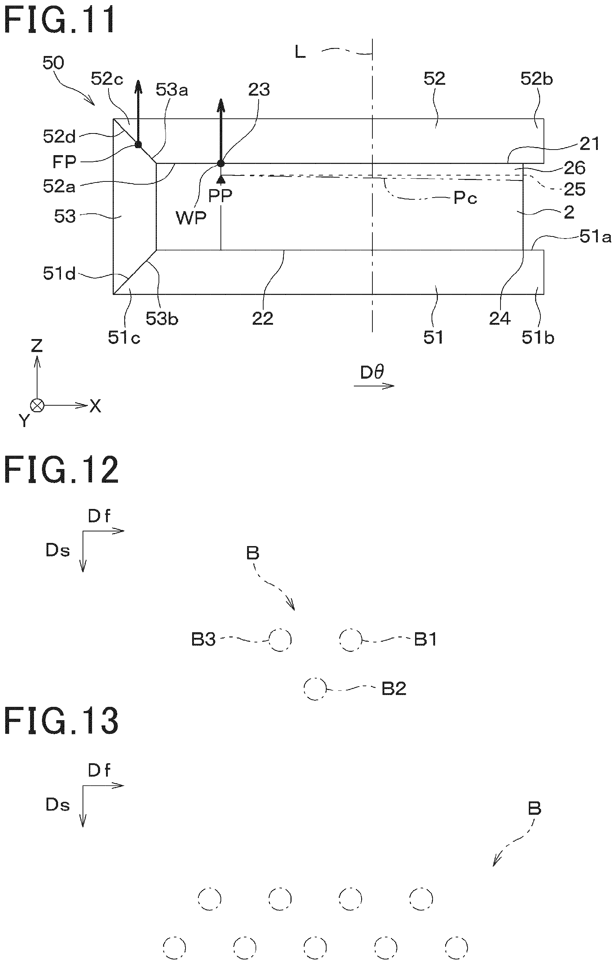

Fig.11 shows a wafer peeling process and an overall configuration of a peeling apparatus 50 used for the wafer peeling process. Note that the right-handed XYZ coordinate shown in Fig.11 is indicated conforming to the right-handed XYZ coordinate shown in Fig.1.

The peeling apparatus 50 is configured to peel the wafer precursor 26 from the ingot 2 at the peeling layer 25 by applying a load in one direction (i.e. unidirectional load) at a first end 23 as one end of the ingot 2 with respect to an in-plane direction parallel to the ingot C-surface 21, that is, the off-angle direction $D\theta$. The first end 23 refers to an end portion at which the off-angle is high, that is, a higher end on the C-surface, i.e. (0001) surface Pc when setting the posture of the ingot 2 such that the ingot C-surface 21 is the upper surface. According to the present embodiment, the peeling apparatus 50 is configured to apply a static and/or a dynamic load at the first end 23 towards the Z-axis direction in Fig.11. Specifically, according to the present embodiment, the peeling apparatus 50 is provided with a support table 51, a peeling pad 52 and a driving member 53.

The support table 51 is provided to support the ingot 2 from the lower side. Specifically, the support table 51 includes, at a support suction surface 51a as an upper surface thereof, many suction holes (not shown) which are open, and suctions the ingot Si surface 22 to the support suction surface 51a by air pressure. The support table 51 includes a first table end 51b and a second table end 51c as both end portions thereof in the off-angle direction $D\theta$. The second table end 51c as an end portion of one side in the off-angle direction $D\theta$ (i.e. left side in Fig.11) includes a table base end surface 51d. The table base end surface 51d is formed as an inclination surface upwardly inclined towards the off-angle direction $D\theta$. In other words, as shown in Fig.11, the support table 51 is formed in a trapezoidal shape in which the lower base is longer than the upper base in a side view.

The peeling pad 52 is provided in the upper side of the support table 51, to be capable of approaching or receding from/to the support table 51 along the Z-axis direction. That is, the peeling apparatus 50 is configured such that the support table 51 and the peeling pad 52 are capable of relatively moving in a height direction of the ingot 2. The peeling pad 52 includes many suction holes (not shown) open at a pad suction surface 52a and configured to suck the ingot C-surface 21 to the pad suction surface 52a with air pressure. The peeling pad 52 includes a first pad end 52b and a second pad end 52c at both ends thereof in the off-angle direction $D\theta$. The second pad end 52c, as an end portion in one side (i.e. left side in Fig.11) of the peeling pad 52 with respect to the off-angle direction $D\theta$, includes a pad end surface 52d. The pad end surface 52d is formed as an inclination surface downwardly inclined towards the off-angle direction $D\theta$. In other words, as shown in Fig.11, the peeling pad 52 is formed in a trapezoidal shape in which the lower base is shorter than the upper base in a side view. The pad end face 52d is provided at a portion corresponding to the table base end surface 51d (i.e. right above). The ingot C-surface 21 is suctioned to the peeling pad 52 to be fixed thereto and the ingot Si surface 22 is suctioned to the support table 51 to be fixed thereto, whereby the ingot 2 is supported between the support table 51 and the peeling pad 52. Hereinafter, the state where the ingot 2 is supported between the support table 51 and the peeling pad 52 is referred to 'supported state'.

The driving member 53 is provided to apply an external force in the supported state to at least one of the support table 51 or the peeling pad 52 such that the support table 51 and the ingot 2 relatively move in the height direction of the ingot 2. Specifically, the driving member 53 includes a first driving end face 53a and a second driving end face 53b. The first driving end face 53a is formed as an inclination surface downwardly inclined towards the off-angle direction $D\theta$. More specifically, the first driving end face 53a is provided to be in parallel to the pad end face 52d. The second driving member end face 53b is formed as an inclination surface upwardly inclined towards the off-angle direction $D\theta$. More specifically, the second driving end face 53b is provided to be parallel to the table base end surface 51d. Further, the driving member 53 is provided such that the first driving end face 53a contacts with the pad end face 52d and the second driving end face 53b contacts the table base end face 51d in the supported state. As shown in Fig.11, the driving member 53 is formed in a shape in which a trapezoid having the lower base longer than the upper base is rotated by 90 degrees in a side view. Then, the driving member 53 is configured to be driven upwardly in a direction along the height direction of the ingot 2 and/or the off-angle direction $D\theta$ as a direction approaching the ingot 2. Specifically, the driving member 53 is driven upwardly and/or in the off-angle direction $D\theta$ such that the ingot 2 is applied with a moment where the second pad end 52c is the force point FP and the first end 23 is the supporting point PP and the working point WP.

The wafer peeling layer for peeling the wafer precursor 26 from the ingot 2 includes a table fixing process, a supporting process and a peeling force application process. The table fixing process sucks the ingot Si surface 22 on the support suction surface 51a to fix the ingot 2 to be on the support table 51. The supporting process sucks the ingot C-surface 21 on the pad suction surface 52a to fix the ingot 2 to be on the peeling pad 52 so as to produce the supported state. The peeling force application process applies static or dynamic force to the ingot 2 with the force point FP which is the second pad end 52c as an end portion of the peeling pad 52 positioned in the one-side thereof with respect to the off-angle direction Dθ, such that a moment of which the supporting point PP is the first end is applied to the ingot 2 in the supported state. Specifically, according to the peeling force application process, the driving member 53 is driven upwardly and/or towards the off-angle direction Dθ in the supported state, whereby the second pad end 52c is pressed upwardly along the height direction of the ingot 2. Thus, the wafer precursor 26 as a part of the ingot 2 can be peeled from the ingot 2 with the peeling layer 25 as a boundary surface.

Thus, according to the present embodiment, the wafter peeling process is performed by applying unidirectional load at the first end 23 as one end of the ingot 2 in the in-plane direction parallel to the upper surface of the ingot 2 (i.e. ingot C-surface 21 in an example shown in Fig.11). Then, a moment is applied to the ingot 2 with the first end 23 as the supporting point PP and the working point WP.

In this respect, according to the wafer peeling process disclosed by Japanese patent number 6678522, the working point PP and the supporting point PP are provided inside the ingot 2, that is, a portion inside an outer periphery of the peeling layer 25 in the in-plane direction. According to this comparative example, a significantly large load is required compared to that of the present embodiment in order to produce better peeling with the peeling layer as the boundary surface. Further, since the load is applied to a wider area of the peeling layer 23, a position of the peeling-crack is not determined so that an unpeeled portion may be partially generated or a breakage may occur on the obtained wafer 1. Further, problems arise that a peeled surface becomes rough and a large processing margin is required for grinding or polishing. Therefore, according to the comparative example, in view point of lowering load and a yield improvement, further improvement is required.

In contrast, in the wafer peeling process of the present embodiment, a unidirectional load is applied to one end of the ingot 2 in the off-angle direction Dθ in order to peel the wafer precursor 26 at the peeling layer 25 from the ingot 2. That is, the load is concentrated at one end of the peeling layer 25 in the off-angle direction Dθ. Then, a moment with the one end as the supporting point PP and the working point WP is applied to the ingot 2. Thus, since peeling progresses starting from cracking produced at an end portion in an one end side of the ingot 2 with respect to the off-angle direction D, it is possible to stably progress the fracture over the entire surface of the peeling layer 25 while reducing the load to be applied. Further, a portion where the fraction occurs is stably set, whereby a surface roughness of the peeling surface 32 of the peeled body 30 or the ingot C-surface 21 can be reduced. In particular, setting the first end 23 as a starting point of occurrence of the fraction to be one end of the higher off-angle side in the off-angle direction Dθ, the fraction occurs smoothly and the cleavage is further stabilized. Accordingly, a failure ratio of the wafer peeling process or a processing margin in the grinding or the polishing of the ingot 2 or the peeled body 30 after completing the wafer peeling process can be favorably reduced. Therefore, according to the present embodiment, a wafer manufacturing method is provided in which a higher manufacturing efficiency is achieved compared to a conventional technique.

(Modification Examples)

The present disclosure is not limited to the above-described embodiments. Hence, the above-described embodiments may be appropriately modified. Hereinafter, typical modification examples will be described. In the following explanation of the modification examples, configurations different from those in the above-described embodiments will mainly be described. Further, in the above-described embodiments and the modification examples, the same reference symbols are applied to mutually the same or equivalent portions. Hence, in the description of the following modification examples, explanations for the above-described embodiments are appropriately used for the configurations having the same reference symbols in the above-described embodiments as long as no technical inconsistency is present or no specific additional explanation is required.

The present disclosure is not limited to the specific configurations described in the above-described embodiments. That is, for example, it is not specifically limited to an outer diameter or a planar shape (e.g. whether so-called orientation flatness is present) of the wafer 1, that is, the ingot 2. Also, for the degree of off-angle θ, it is not limited thereto. Further, according to the above-described embodiments, the wafer C-surface 11 and the ingot C-surface are not the same as a C-surface in a strict crystallographic sense, that is, (0001) surface Pc. However, even in this case, since the above C-surfaces are allowed to be generally referred to as C-surface, the expression 'C-surface' is used in this specification. However, the present disclosure is not limited to the above aspect. The above-described wafer C-surface 11 or the ingot C-surface 21 may be the same as the C-surface Pc in a strict crystallographic sense. In other words, the off-angle θ may be 0 degree.

An irradiation condition or a scanning condition may not be limited to the specific examples in the above-described embodiments. For example, an arrangement of a plurality of laser beams B irradiated at one laser scanning may be appropriately modified from the specific examples shown in Fig.5A. Specifically, as shown in Fig. 12, the first beam B 1, the second beam B2 and the third beam B3 arranged at mutually different positions in the line feed direction Df (i.e. second direction) may be arranged in a V-shape on the laser irradiation surface. More specifically, the first beam B 1, the second beam B2 and the third beam B3 are arranged along the line feed direction Df in this order. The second beam B2 is provided at a portion protruding in the scanning direction Ds compared to the first beam B 1 and the third beam B3. In other words, as shown in Fig. 13, the plurality of laser beams B may be arranged in W-shape or in zigzag as shown in Fig. 13. According to the arrangement of the plurality of laser beams B, a subsequent modified layer is formed with a wider interval than a length of cleavage occurring in the modified layer previously processed, whereby interference between the cleavage and the subsequent modified layer can be suppressed. Further, in the backward scanning Sc2, when the laser beam B is irradiated to the entire width region of the ingot 2 in the scanning direction Ds similar to the forward scanning Sc1, the irradiation conditions thereof may be differentiated. Specifically, for example, a distance (i.e. irradiation distance) from the laser irradiation surface of the beam condensing apparatus 42 (i.e. ingot C-surface 21) may be changed.

Depending on the irradiation condition or the scanning condition, the peeling surface 32 may already have a surface condition to which grinding or a polishing can be favorably applied even in the ECMG process. Hence, a rough grinding process of the peeling surface 32 shown in Fig.2 may be omitted. The same applies to a rough grinding for the upper surface of the ingot 2 after completing the wafer peeling process.

Figs.4A or 4B illustrates the peeling layer forming apparatus 40 as a simplified overall diagram in order to simply explain an overall peeling layer forming process according to the present embodiment. Hence, the specific configuration of the peeling layer forming apparatus 40 actually utilized in the manufacturing process is not necessarily the same as the configuration exemplified in Figs.4A and 4B. Specifically, for example, the chuck table 41 may be configured to support the ingot 2 using a method other than the suction mechanism with an air pressure. Further, the chuck table 41 may be configured to be capable of relatively moving in at least the in-plane direction, that is, XY direction in the drawing, with respect to the beam condensing apparatus 42. Alternatively, the peeling layer forming apparatus 40 may be provided with a scanning apparatus capable of causing the focus point BP of the laser beam B to relatively move in the XYZ direction with respect to the ingot 2. Moreover, according to the above-described embodiments, the peeling layer forming apparatus 40 is configured such that the chuck table 41 that supports the ingot 2 is capable of moving at least in the in-plane direction, while the beam condensing apparatus 42 is provided to be fixed in the in-plane direction. However, the present disclosure is not limited to these embodiments. Specifically, for example, the peeling layer forming apparatus 40 may be configured such that the chuck table 41 is provided to be fixed in the in-plane direction and the beam condensing apparatus 42 moves in the in-plane direction using a scanning apparatus which is not shown. Also, according to the present disclosure, depending on whether it is the facet region RF or the non-facet region RN or regardless of whether it is the facet region RF or the non-facet region RN, a distance adjustment between the beam condensing apparatus 42 in the irradiation side of the laser beam B and the chuck table 41 that supports the ingot 2 may be arbitrarily performed. Furthermore, the specific configuration of the peeling layer forming apparatus 40 actually utilized in the manufacturing process may be accomplished with an appropriate modification from the configurations exemplified in Figs.4A and 4B.

In the above-described embodiments, the peeling layer 25 is formed in the ingot C-surface 21 side with a C-surface side irradiation in which the laser beam B is irradiated to the ingot C-surface 21. However, the present disclosure is not limited to these embodiments. The present disclosure may be applicable to a Si surface side irradiation in which the laser beam B is irradiated to the ingot Si surface 22 to form the peeling layer 25 in the ingot Si surface 22 side.

Fig. 11 illustrates the peeling apparatus 50 as a simplified overall diagram in order to simply explain an overall wafer peeling process according to the present embodiment. Hence, the specific configuration of the peeling apparatus 50 actually utilized in the manufacturing process is not necessarily the same as the configuration exemplified in Fig11. Specifically, for example, the support table 51 may be configured to suction the ingot Si surface 22 to the support suction surface 51a using a method other than a suction mechanism using air pressure (e.g. using a wax or an adhesive material).

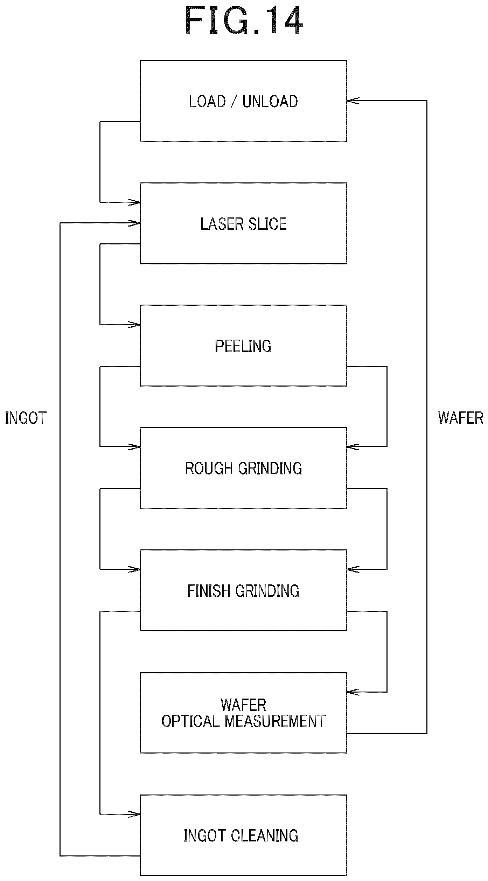

The optical characteristics, that is, a transmittance and a refractive index of the obtained wafer 1 or the peeling body 30 may be measured at a plurality of positions in the scanning direction Ds and the line feed direction Df and an irradiation condition of the subsequent laser beam B may be controlled based on the measurement result. Fig. 14 is a diagram showing an overall configuration of this embodiment. In Fig. 14, 'load/unload' refers to a load and an unload process of the peeling body 39 or the ingot 2 as an obj ect to be processed, 'laser slicing' refers to a peeling layer forming process, 'peeling' refers to wafer peeling process, and 'rough grinding' refers to a process for roughly grinding the major surface of the ingot 2 or the peeling body 30. For the rough grinding, approximately number #800 grinding material can be used. Moreover, 'finish grinding' refers to a process for finishing the grinding. For the finish grinding, approximately a number #30000 grinding material can be used. 'Wafer optical measurement' refers to a process for measuring the optical characteristics (i.e. transmittance or refractive index) of the peeling body 30 to which the finish grinding was applied at a plurality of positions in the scanning direction Ds and the line feed direction Df. 'Ingot cleaning' refers to a process for cleaning the ingot 2 after the finish grinding is applied. In the drawing, arrows in the left side of blocks indicating respective processes refers to a process flow applied to the ingot 2 and arrows in the right side of blocks indicating respective process refers to a process flow applied to the wafer 1 or the peeling body 30 which is commonly referred to as a wafer.

Referring to Fig. 14, firstly, an ingot 2 is loaded to the wafer manufacturing apparatus including the peeling layer forming apparatus 40. Next, the peeling layer forming process with an irradiation of the laser beam B is performed for the loaded ingot 2. Subsequently, in the wafer peeling process, the peeling body 30 is peeled from the ingot 2 to which the peeling layer forming process was applied. Rough grinding and finish grinding are applied to an upper surface of the ingot 2 newly generated on the ingot 2 to which the wafer peeling process was applied, whereby the upper surface of the ingot 2 is planarized. Thereafter, the ingot 2 is cleaned and the peeling layer forming process is again applied to the cleaned ingot 2. Note that the ingot 2 after the peeling layer forming process or the ingot cleaning process is completed, is unloaded from the wafer manufacturing apparatus when the height thereof is less than a predetermined value.

The peeling body 30 peeled from the ingot 2 in the wafer peeling process is applied with the rough grinding and the finish girding, and then is provided for optical measurement, that is, transmittance and refractive index. The measurement result is used for determining an irradiation condition of the laser beam B (e.g. irradiation energy and/or irradiation distance) in the next peeling layer forming process. In other words, the irradiation condition is controlled, based on the measurement result of the transmittance and the refractive index in each position of the wafer 1 in the in-plane direction, for each position of the ingot C-surface 21 in the in-plane direction during the next peeling layer forming process. Thus, the irradiation condition can be precisely changed corresponding to variation of the optical characteristics in respective positions in the in-plane direction, whereby material wastage can be reduced. In particular, this is effective for a case where the ingot 2 has a facet region RF. Note that either the transmittance or the refractive index may be measured. Alternatively, the measurement for the transmittance and the refractive index may be applied to an epi-ready wafer 1 as a completed product. Further, depending on the rough grinding condition (e.g. ECMG case), the finish grinding may be unnecessary. That is, the rough grinding and the finish grinding can be integrated to be one process.

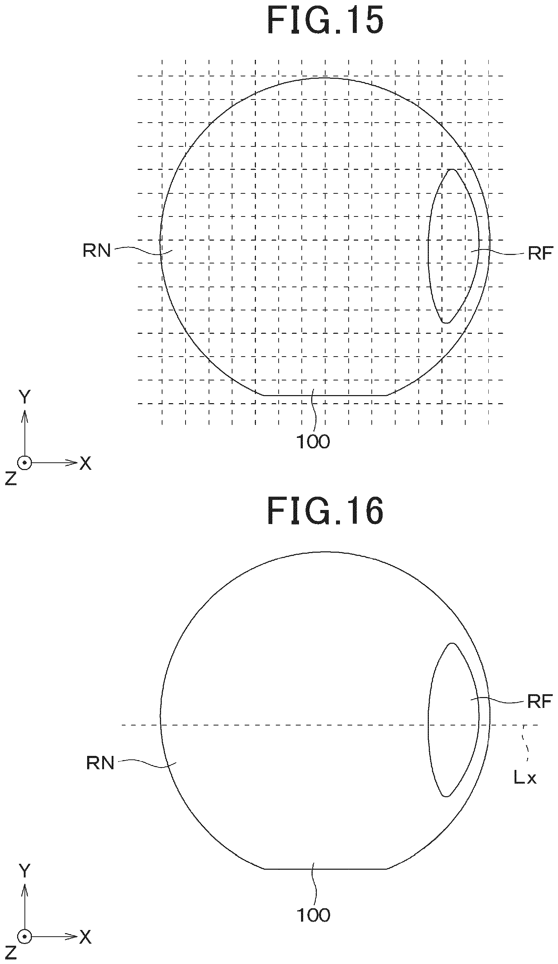

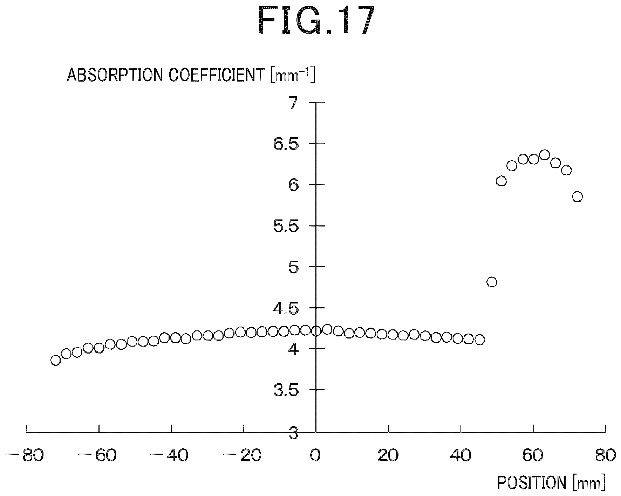

Fig. 15 illustrates an example for setting an optical measurement position of a produced body 100. The produced body 100 is an object of an optical measurement and corresponds to the peeling body 30 of which the surface is planarized to a certain degree after being peeled from the ingot 2. In this example, the optical measurement position is set with a constant pitch (e.g. 3 mm) in the X axis direction (i.e. first direction) and the Y axis direction (second direction). The X axis direction is parallel to the scanning direction Ds shown in Fig.6 and the like. Also, the Y axis direction is parallel to the line feed direction Df shown in Fig.6 and the like. Here, Fig. 17 shows a change in the absorption coefficient for the laser beam B accompanied with a change in the measurement position in the case where an optical measurement is performed for a plurality of measurement positions on a measurement line Lx as shown in Fig. 16. The measurement line Lx is a virtual line parallel to the X axis, passing through the center of the produced body 100 in-plane direction and the facet region RF. The absorption coefficient is acquired, that is, calculated, using the following equation (1). In the equation (1), $\alpha$ indicates an absorption coefficient, D indicates a work-thickness, that is, a thickness of the produced body 100, and T indicates a transmittance.

[Math 1]

$$\alpha = - 1/D \ln (T)$$

In Fig. 17, the horizontal axis indicates a measurement position where the center of the produced body 100 in the in-plane direction is defined as the origin, that is, 0. As shown in Fig. 17, the absorption coefficient is not constant with respect to the in-plane direction, and changes accompanied with a change in the measurement position. Specifically, a region having higher absorption coefficient shown in the right end side of Fig. 17 corresponds to the facet region RF. Further, also in the non-facet region RN having lower absorption coefficient than that of the facet region RF, the absorption coefficient is distributed in the in-plane direction, that is, the radial direction. The radial direction is a direction radially extending from the center of the produced body 100 in the in-plane direction. Specifically, in the example shown in Fig. 17, a region having a lower absorption coefficient is present in a left side relative to the center position, that is, the outer side.

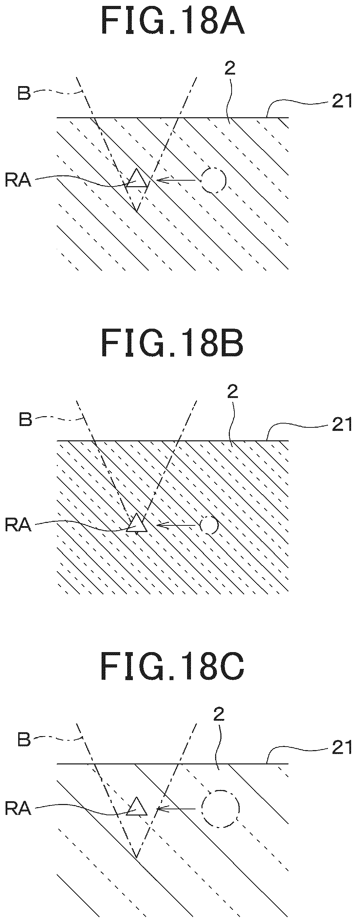

Fig. 18A to Fig. 18C illustrate a change in the position where the modified layer occurs (i.e. modified layer occurrence position) accompanied with a change in the transmittance, that is, absorption coefficient. The modified layer occurrence position refers to a position where a modified layer, that is, an irradiation influenced region RA is produced due to the laser beam B being focused. The modified layer occurrence position may be indicated by a dimension from the ingot C-surface as the laser irradiation surface in the depth direction of the ingot 2. Here, the depth direction of the ingot 2 refers to a direction parallel to the height direction of the ingot 2, and more specifically to a direction opposite to the height direction (i.e. Z-axis negative direction). In the drawings, a circle indicated by a one-dot chain line positioned in a side of the irradiation influenced region RA refers to a condensing state of the laser beam B, that is, a beam diameter.

Referring to Fig. 18A, when the laser beam B propagates inside the ingot 2 in the depth direction, the laser beam B is condensed while being attenuated in accordance with the absorption coefficient. Then, when the energy density increases by a predetermined degree due to the beam condensing, and reaches a processing threshold, a modified layer, that is, the irradiation influenced region RA is formed. In the case where the transmittance is low (i.e. absorption coefficient is high), since an amount of attenuation is large, as shown in Fig. 18B, the energy density reaches the processing threshold at a depth position where a cross-sectional area of beam condensing is smaller and modification occurs. On the other hand, in the case where the transmittance is high (i.e. absorption coefficient is low), since an amount of attenuation is low, as shown in Fig. 18C, the energy density reaches the processing threshold even at a shallow depth position in which the cross-sectional area of beam condensing is larger and modification occurs. Thus, when the modified layer occurrence position varies depending on a change in the transmittance, that is, the absorption coefficient, the surface of the produced body 100 after peeling becomes rough and causes a large loss of processing margin of the grinding or the polishing, that is, a large material wastage.

In this respect, according to the present modification example, the transmittance is measured at a plurality of positions in the in-plane direction, and controls the irradiation condition of the laser beam B at a respective plurality of positions, based on the measurement result. Specifically, according to the present modification example, the absorption coefficient is acquired (calculated) based on the transmittance measured for the produced body 100 generated in the past including the previous time. Then, according to the present modification example, the irradiation energy of the laser beam B is determined based on a tendency of a change in the absorption coefficient in the depth direction of the ingot 2 at respective different positions in a plane across the surface.

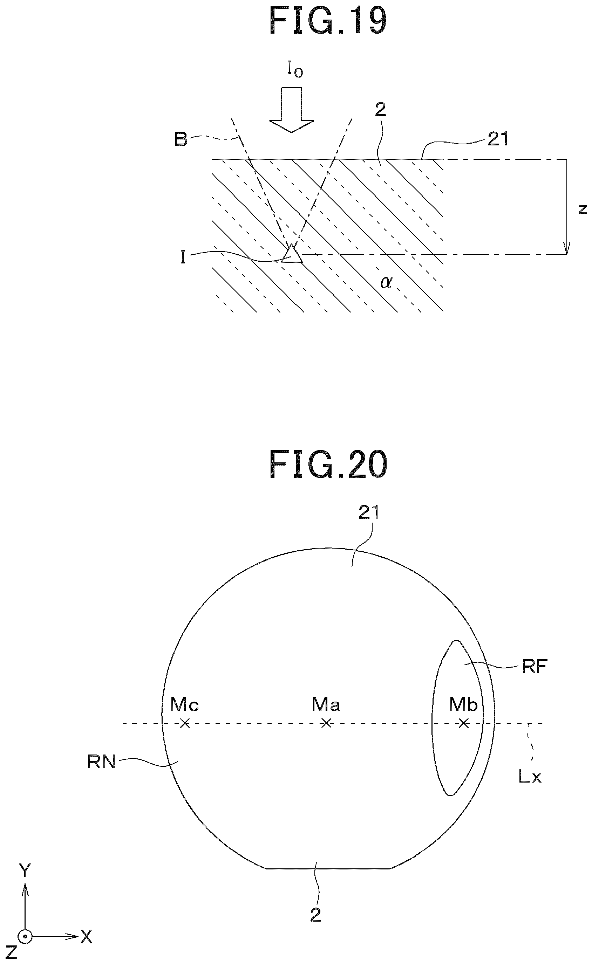

Hereinafter, one specific example for controlling the irradiation condition of the subsequent laser beam B in accordance with an optical measurement result of the produced body 100 acquired at the previous time will be described. Firstly, a transmittance measurement unit is used to measure the transmittance and the like of the produced body acquired in the previous time. At this time, a work thickness is also measured. The absorption coefficient is calculated based on the measured transmittance, the work thickness and the above-described equation (1). Then, an input energy which is an irradiation energy of the laser beam B is calculated using the following equation (2). In the following equation (2) and Fig. 19, Io indicates an input energy, I indicates required energy for a processing point, that is, minimum application energy necessary for the modification, z indicates a depth, and k indicates an amount of change in the absorption coefficient in the depth direction, that is, a tendency of a change in the absorption coefficient in the depth direction of the ingot 2.

[Math2]

$$\mathrm{Io} = \mathrm{k} \cdot \mathrm{I} \cdot \mathrm{e}^{\alpha Z}$$

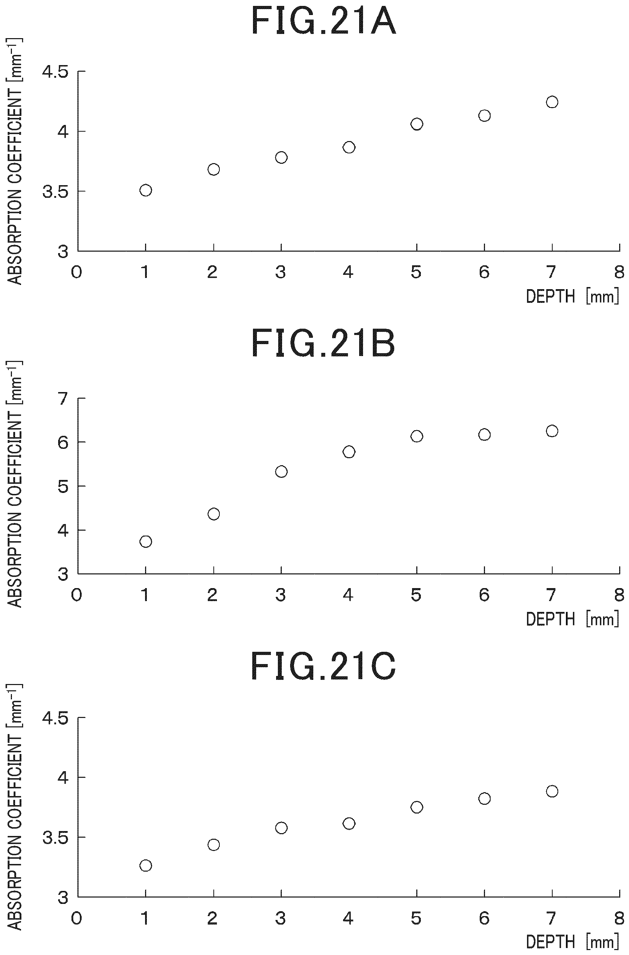

A method for deriving an absorption coefficient will be described as follows. As shown in Fig.20, the center of the ingot 2 in the in-plane direction is defined as in-plane center position Ma. Further, a first end position Mb is defined as an end position of the ingot 2 in the facet region RF positioned on a measurement line Lx passing through the in-plane center position Ma and parallel to the X axis. Moreover, a position opposite to the first end position Mb on the measurement line Lx is defined as a second end position Mc. The second end position Mc is a position substantially symmetric to the first end position Mb with the in-plane center position Ma as the symmetric center. Fig.21A shows a change in the absorption coefficient at the in-plane center position Ma in the depth direction of the ingot 2. Fig.21B shows a change in the absorption coefficient at the first end position Mb in the depth direction of the ingot 2. Fig.21C shows a change in the absorption coefficient at the second end position Mc in the depth direction of the ingot 2. As shown in Figs.21A to 21C, a change in the absorption coefficient in the depth direction of the ingot 2 has a specific tendency and differs between the in-plane positions. An amount of change in the absorption coefficient is derived based on the tendency of the change in the absorption coefficient in the depth direction at respective in-plane positions. Then, a value where the derived amount of change in the absorption coefficient is added to the previously acquired absorption coefficient or a value where the previously acquired absorption coefficient is multiplied by the derived amount of change in the absorption coefficient may be utilized for determining the input energy for the next processing.

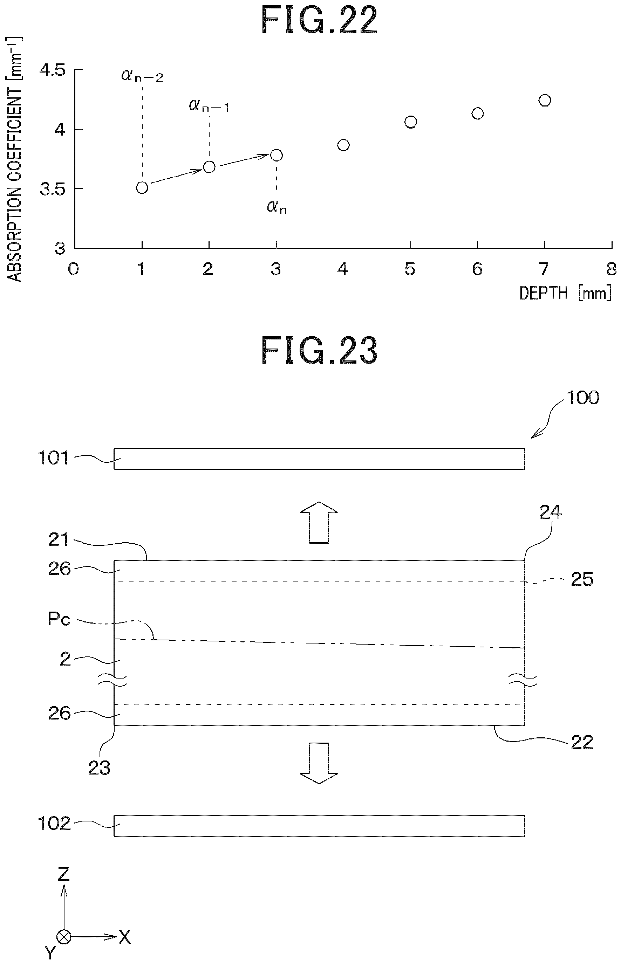

For example, as shown in Fig.22, an estimated absorption coefficient value $\alpha_n$ used for the current processing can be acquired (calculated) based on a previously acquired absorption coefficient $\alpha_{n-1}$ and an absorption coefficient $\alpha_{n-2}$ acquired before the previously acquired absorption coefficient $\alpha_{n-1}$. Specifically, for example, a difference between the previously acquired absorption coefficient $\alpha_{n-1}$ and absorption coefficient $\alpha_{n-2}$ acquired before the previously acquired absorption coefficient $\alpha_{n-1}$ is defined as an absorption coefficient change amount. Then, the absorption coefficient change amount is added to the previously acquired absorption coefficient $\alpha_{n-1}$, thereby calculating an estimated absorption coefficient value $\alpha_n$. The irradiation energy of the laser beam B can be determined based on the estimated absorption coefficient value $\alpha_n$. Note that a statistical process using an averaging filter may be applied for calculating the absorption coefficient change amount.

Also, as shown in Fig.23, a first produced body 101 and a second produced body 102 are generated. The first produced body 101 is a body in which the produced body 100 is obtained from one end side of the ingot 2 with respect to the height direction thereof, that is, the ingot C-surface 21 side. The second produced body 102 is a body in which the produced body 100 is obtained from the other end side of the ingot 2 with respect to the height direction thereof, that is, the ingot Si-surface 22 side. Subsequently, a first absorption coefficient as an absorption coefficient in the first produced body 101 and a second absorption coefficient as an absorption coefficient in the second produced body 102 are acquired. Then, a higher value between the first absorption coefficient and the second absorption coefficient is determined as an upper limit value of the absorption coefficient and the irradiation condition (i.e. the irradiation energy) of the laser beam B can be determined. In other words, an absorption coefficient acquired from the produced body 100 (i.e. wafer) having higher absorption coefficient may be set to be the upper limit value, and the coefficient may be set not to exceed the upper limit value.

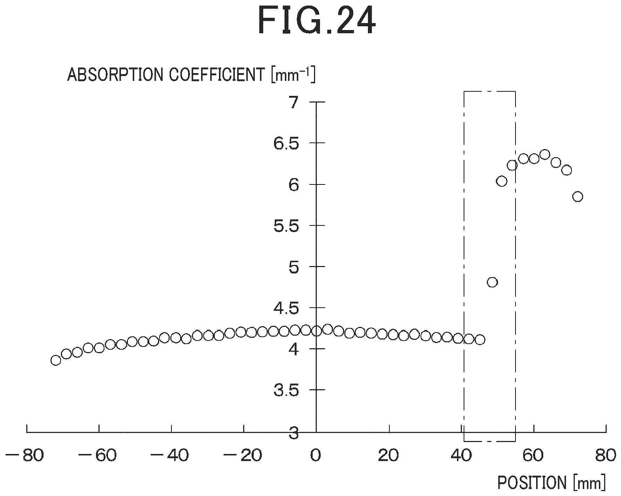

The measurement pitch of the optical measurement may be an equal pitch shown in Fig. 15, but may be appropriately changed. Specifically, for example, the measurement pitch may be set to be different between the X axis direction and the Y axis direction. Alternatively, for example, the measurement pitch may be set to be narrower in a region surrounded by a rectangle indicated by a one dot chain line shown in Fig.24, that is, in a region where a change in the absorption coefficient is larger than that of other regions. This region is, for example, a boundary region between the non-facet region RN and the facet region RF. The measurement pitch in the boundary region may be narrower than that of other regions. Note that the region where the measurement pitch is set to be narrower may include the entire facet region RF. More specifically, for example, referring to Fig.24, the measurement pitch may be set to be narrower in a right side region of the measurement position at 40mm than a left side region of the measurement position at 40mm. In other words, in a predetermined region configured of the non-facet region RN and a boundary region between the non-facet region RN and the facet region RF, the measurement pitch may be set to be narrower than an outer side region of the predetermined region.

For the above-described configurations, effects and advantages were confirmed by experiment. The laser beam B used for the experiments is a pulse laser having wavelength 1064nm, pulse width 7ns and oscillation frequency 25KHz. Further, the laser beam B is an annular beam of which the external diameter is 4.85mm, and the internal diameter is 2.82mm. The laser beam B is caused to be incident on a lens having NA of 0.65 and processing performed with an irradiation pitch (i.e. irradiation interval in the scanning direction Ds) of 8μm and a scanning interval (i.e. interval of the scanning line Ls in the line feed direction Ds) 120μm The ingot 2 to be processed is utilized in which an outer diameter is 6 inch, and a difference between absorption coefficients in the surface direction is 2.49mm$^{-1}$. The measurement of transmittance was performed for a previously cut wafer 1 having a thickness of 0.385mm with 3mm pitch. The input energy was set such that 20uJ energy was inputted at the 0.4mm depth position in the center part of the ingot 2, to obtain output of the laser beam B. At this moment, when processing was performed under a constant output, the height difference between the modified layer occurrence positions was 61μm. However, with an output correction depending on a change in the absorption coefficient in the surface direction, the height difference between the modified layer occurrence positions was improved to be 18μm. Thus, it was confirmed that material wastage was reduced.

In the above-described embodiments, elements constituting the embodiments are not necessarily required except that elements are clearly specified as necessary or theoretically necessary. Even in the case where numeric values are mentioned in the above-described embodiments, such as the number of constituents, numeric values, quantity, range or the like, it is not limited to the specific values unless it is specified as necessary or theoretically limited to specific numbers. In the case where shapes, directions, positional relationships and the like are mentioned for the constituents in the above-described embodiments, it is not limited to the shapes, directions and positional relationships except where they are clearly specified or theoretically limited to specific shapes, directions, positional relationships and the like.

The modification examples are not limited to the above-described examples. For example, a plurality of embodiments other than the above-described examples may be mutually combined as long as no technical inconsistency is present. Similarly, a plurality of modification examples may be mutually combined as long as no technical inconsistency is present.

(Aspects of the disclosure)

As is clear from the description of the embodiments and modification examples as described above, the present specification discloses at least following aspects.

[First aspect]

A wafer manufacturing method for obtaining a wafer (1) from an ingot (2), comprising steps of

a peeling layer forming step that irradiates a surface (21) of one end side of the ingot in a height direction thereof with a laser beam to which the ingot has transparency, thereby forming a peeling layer at a depth position corresponding to a thickness of the wafer from the surface;

a wafer peeling step that peels a wafer precursor (26) as a portion between the surface and the peeling layer from the ingot, the wafer precursor being peeled at the peeling layer; and

a wafer planarization step that planarizes a major surface (32) of a peeling body (30) having a plate like shape, the peeling body being obtained by the wafer peeling step,

wherein

in the peeling layer forming step, the laser beam is irradiated to the surface such that a frequency of irradiation of the laser beam for the facet region (RF) is set to be higher than that for the non-facet region (RN).

[Second aspect]

In the second aspect, the first aspect is modified such that the ingot is a single crystal SiC ingot having c-axis (Lc) and C surface (Pc) which orthogonally cross each other; the c-axis is provided in a state where a center axis (L) orthogonal to the surface is inclined in an off-angle direction (Dθ) by an off-angle (θ) which exceeds 0 degree; the peeling layer forming step is performed such that the facet region is positioned in a lower side on the C-surface when setting a posture of the ingot such that the surface is an upper surface thereof.

[Third aspect]

In the third aspect, the second aspect is modified such that the wafer peeling step is performed by applying one-directional load at an one end (23) of the ingot in the off-angle direction.

[Fourth aspect]

In the fourth aspect, the third aspect is modified such that the one end of the ingot in the off-angle direction is defined as a higher side end portion on the C-surface when setting a posture of the ingot such that the surface is an upper surface thereof.

[Fifth aspect]

In the fifth aspect, any one of first to fourth aspects is modified such that the peeling layer forming step is performed in the following manner: a laser scanning in which the laser beam is caused to irradiate the surface while moving an irradiation position (PR) of the laser beam on the surface in a first direction (Ds) along the surface, is performed for a plurality of times while changing a position on the surface in a second direction (Df) orthogonal to the first direction along the surface, to form a plurality of scanning line (Ls) along the second direction, each scanning line being an irradiation mark of the laser beam, having a linear shape along the first direction, thereby forming the peeling layer; when moving the irradiation position in the first direction, the scanning line is formed between both ends of the surface in the first direction; and when moving the irradiation position in a direction opposite to the first direction, the irradiation mark is formed at an end portion of the surface in the first direction.

[Sixth aspect]

In the sixth aspect, any one of first to fourth aspects is modified such that the peeling layer forming step is performed in the following manner: a laser scanning in which the laser beam is caused to irradiate the surface while moving an irradiation position (PR) of the laser beam on the surface in a first direction (Ds) along the surface, is performed for a plurality of times while changing a position on the surface in a second direction (Df) orthogonal to the first direction along the surface, to form a plurality of scanning line (Ls) along the second direction, each scanning line being an irradiation mark of the laser beam, having a linear shape along the first direction, thereby forming the peeling layer; and

a distance from the surface to a beam condensing apparatus (42) which irradiates the surface with the laser beam is changed between a case when moving the irradiation position in the first direction and a case when moving the irradiation position in a direction opposite to the first direction.

[Seventh aspect]

In the seventh aspect, any one of first to sixth aspects is modified such that a transmittance of the peeling body or an obtained wafer is measured at a plurality of positions in a first direction (Ds) along the surface and a second direction (Df) orthogonal to the first direction along the surface; and an irradiation condition of the laser beam at each of the positions is controlled based on a measurement result of the transmittance.

[Eighth aspect]

In the eighth aspect, the seventh aspect is modified such that an absorption coefficient of the laser beam is acquired based on the transmittance; and an irradiation energy of the laser beam is determined based on a tendency of a change in the absorption coefficient in a depth direction of the ingot at respective different positions in a plane across the surface.

[Ninth aspect]

In the ninth aspect, the eighth aspect is modified such that an amount of change in an absorption coefficient in the depth direction is acquired based on a tendency of a change in the absorption coefficient in the depth direction of the ingot; and an irradiation energy of the laser beam is determined based on a value where the amount of change in the absorption coefficient is added to a previously acquired absorption coefficient or a value where the previously acquired absorption coefficient is multiplied by the amount of change in the absorption coefficient.

[Tenth aspect]

In the tenth aspect, any one of eighth and ninth aspects is modified such that an irradiation energy of the laser beam is determined based on an estimated absorption coefficient value acquired in accordance with a previously acquired absorption coefficient and an absorption coefficient acquired before the previously acquired absorption coefficient.

[Eleventh aspect]

In the eleventh aspect, any one of eighth to tenth aspects is modified such that a first produced body (101) as the peeling body or the wafer obtained from the ingot at one end side thereof in the height direction, and a second produced body (102) as the peeling body or the wafer obtained from the ingot at the other end side thereof in the height direction are generated; a first absorption coefficient as the absorption coefficient of the first produced body and a second absorption coefficient as the absorption coefficient of the second produced body are acquired; and a higher value between the first absorption coefficient and the second absorption coefficient is determined as an upper limit value of the absorption coefficient and thereby an irradiation energy of the laser beam is determined.

[Twelfth aspect]

In the twelfth aspect, any one of seventh aspect to eleventh aspect is modified such that in a second region having higher amount of change in the absorption coefficient than that of a first region, a measurement pitch of the transmittance is set to be narrower than that of the first region.

[Thirteenth aspect]

In the thirteenth aspect, the twelfth aspect is modified such that the second region is a boundary region between a non-facet region (RN) and a facet region (RF).

**Claims**

1. A wafer manufacturing method for obtaining a wafer (1) from an ingot (2), comprising steps of

   a peeling layer forming step that irradiates a surface (21) of one end side of the ingot in a height direction thereof with a laser beam to which the ingot has transparency, thereby forming a peeling layer at a depth position corresponding to a thickness of the wafer from the surface;
   a wafer peeling step that peels a wafer precursor (26) as a portion between the surface and the peeling layer from the ingot, the wafer precursor being peeled at the peeling layer; and
   a wafer planarization step that planarizes a major surface (32) of a peeling body (30) having a plate like shape, the peeling body being obtained by the wafer peeling step,
   wherein
   in the peeling layer forming step, the laser beam is irradiated to the surface such that a frequency of irradiation of the laser beam for the facet region (RF) is set to be higher than that for the non-facet region (RN).

2. The wafer manufacturing method according to claim 1,
   wherein

   the ingot is a single crystal SiC ingot having c-axis (Lc) and C surface (Pc) which orthogonally cross each other;
   the c-axis is provided in a state where a center axis (L) orthogonal to the surface is inclined in an off-angle direction (Dθ) by an off-angle (θ) which exceeds 0 degree;
   the peeling layer forming step is performed such that the facet region is positioned in a lower side on the C-surface when setting a posture of the ingot such that the surface is an upper surface thereof.

3. The wafer manufacturing method according to claim 2,
   wherein
   the wafer peeling step is performed by applying one-directional load at a one end (23) of the ingot in the off-angle direction.

4. The wafer manufacturing method according to claim 3,
   wherein
   the one end of the ingot in the off-angle direction is defined as a higher side end portion on the C-surface when setting a posture of the ingot such that the surface is an upper surface thereof.

5. The wafer manufacturing method according to claim 1,
   wherein
   the peeling layer forming step is performed in the following manner:

   a laser scanning in which the laser beam is caused to irradiate the surface while moving an irradiation position (PR) of the laser beam on the surface in a first direction (Ds) along the surface, is performed for a plurality of times while changing a position on the surface in a second direction (Df) orthogonal to the first direction along the surface, to form a plurality of scanning line (Ls) along the second direction, each scanning line being an irradiation mark of the laser beam, having a linear shape along the first direction, thereby forming the peeling layer,
   when moving the irradiation position in the first direction, the scanning line is formed between both ends of the surface in the first direction; and
   when moving the irradiation position in a direction opposite to the first direction, the irradiation mark is formed at an end portion of the surface in the first direction.

6. The wafer manufacturing method according to claim 1,
   wherein
   the peeling layer forming step is performed in the following manner:

   a laser scanning in which the laser beam is caused to irradiate the surface while moving an irradiation position (PR) of the laser beam on the surface in a first direction (Ds) along the surface, is performed for a plurality of times while changing a position on the surface in a second direction (Df) orthogonal to the first direction along the surface, to form a plurality of scanning line (Ls) along the second direction, each scanning line being an irradiation mark of the laser beam, having a linear shape along the first direction, thereby forming the peeling layer; and
   a distance from the surface to a beam condensing apparatus (42) which irradiates the surface with the laser beam is changed between a case when moving the irradiation position in the first direction and a case when moving the irradiation position in a direction opposite to the first direction.

7. The wafer manufacturing method according to claim 1,
   wherein

   a transmittance of the peeling body or an obtained wafer is measured at a plurality of positions in a first direction (Ds) along the surface and a second direction (Df) orthogonal to the first direction along the surface; and
   an irradiation condition of the laser beam at each of the positions is controlled based on a measurement result of the transmittance.

8. The wafer manufacturing method according to claim 7,
   wherein

   an absorption coefficient of the laser beam is acquired based on the transmittance; and
   an irradiation energy of the laser beam is determined based on a tendency of a change in the absorption coefficient in a depth direction of the ingot at respective different positions in a plane across the surface.

9. The wafer manufacturing method according to claim 8,
   wherein

   an amount of change in an absorption coefficient in the depth direction is acquired based on a tendency of a change in the absorption coefficient in the depth direction of the ingot; and
   an irradiation energy of the laser beam is determined based on a value where the amount of change in the absorption coefficient is added to a previously acquired absorption coefficient or a value where the previously acquired absorption coefficient is multiplied by the amount of change in the absorption coefficient.

10. The wafer manufacturing method according to claim 8,
    wherein
    an irradiation energy of the laser beam is determined based on an estimated absorption coefficient value acquired in accordance with a previously acquired absorption coefficient and an absorption coefficient acquired before the previously acquired absorption coefficient.

11. The wafer manufacturing method according to claim 8,
    wherein

    a first produced body (101) as the peeling body or the wafer obtained from the ingot at one end side thereof in the height direction, and a second produced body (102) as the peeling body or the wafer obtained from the ingot at the other end side thereof in the height direction are generated;
    a first absorption coefficient as the absorption coefficient of the first produced body and a second absorption coefficient as the absorption coefficient of the second produced body are acquired; and

a higher value between the first absorption coefficient and the second absorption coefficient is determined as an upper limit value of the absorption coefficient and thereby an irradiation energy of the laser beam is determined.

12. The wafer manufacturing method according to claim 8,

wherein

in a second region having higher amount of change in the absorption coefficient than that of a first region, a measurement pitch of the transmittance is set to be narrower than that of the first region.

13. The wafer manufacturing method according to claim 12,

wherein

the second region is a boundary region between a non-facet region (RN) and a facet region (RF).

# FIG.1

# FIG.2

INGOT

FORM PEELING LAYER

PEELING

ROUGH GRINDING OF
WAFER Si SURFACE

ROUGH GRINDING OF
INGOT C-SURFACE

ECMG FOR WAFER Si
SURFACE

FINISH GRINDING OF
INGOT C-SURFACE

ECMP FOR WAFER Si
SURFACE

INGOT CLEAN

WAFER CLEAN

EPI READY WAFER

# FIG.3A

# FIG.3B

# FIG.4A

# FIG.4B

# FIG.5A

# FIG.5B

# FIG.6

# FIG.7

# FIG.8A

# FIG.8B

# FIG.9

# FIG.10

# FIG.11

# FIG.12

# FIG.13

# FIG.14

# FIG.15

# FIG.16

# FIG.17

# FIG.18A

# FIG.18B

# FIG.18C

# FIG.19

# FIG.20

# FIG.21A

# FIG.21B

# FIG.21C

# FIG.22

# FIG.23

# FIG.24

## INTERNATIONAL SEARCH REPORT

| International application No. |
|---|
| **PCT/JP2022/041571** |

**A. CLASSIFICATION OF SUBJECT MATTER**

***H01L 21/304***(2006.01)i; ***B23K 26/53***(2014.01)i
FI: H01L21/304 611Z; H01L21/304 621B; B23K26/53

According to International Patent Classification (IPC) or to both national classification and IPC

**B. FIELDS SEARCHED**

Minimum documentation searched (classification system followed by classification symbols)

H01L21/304; B23K26/53

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2020-77783 A (DISCO ABRASIVE SYST., LTD.) 21 May 2020 (2020-05-21) entire text, all drawings | 1-13 |
| A | JP 2020-47619 A (DISCO ABRASIVE SYST., LTD.) 26 March 2020 (2020-03-26) entire text, all drawings | 1-13 |
| A | JP 2020-31134 A (DISCO ABRASIVE SYST., LTD.) 27 February 2020 (2020-02-27) entire text, all drawings | 1-13 |
| A | JP 2017-220631 A (DISCO ABRASIVE SYST., LTD.) 14 December 2017 (2017-12-14) entire text, all drawings | 1-13 |
| A | WO 2020/090896 A1 (HAMAMATSU PHOTONICS K.K.) 07 May 2020 (2020-05-07) entire text, all drawings | 1-13 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **10 January 2023** | **24 January 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2022/041571**

| Patent document cited in search report | | | Publication date (day/month/year) | Patent family member(s) | | | Publication date (day/month/year) |
|---|---|---|---|---|---|---|---|
| JP | 2020-77783 | A | 21 May 2020 | US 2020/0150038 entire text, all drawings KR 10-2020-0053410 CN 111162017 | A1 A A | | |
| JP | 2020-47619 | A | 26 March 2020 | US 2020/0086426 entire text, all drawings CN 110911268 KR 10-2020-0031515 | A1 A A | | |
| JP | 2020-31134 | A | 27 February 2020 | US 2020/0064269 entire text, all drawings CN 110858550 KR 10-2020-0022332 | A1 A A | | |
| JP | 2017-220631 | A | 14 December 2017 | (Family: none) | | | |
| WO | 2020/090896 | A1 | 07 May 2020 | US 2022/0009038 entire text, all drawings CN 112955279 KR 10-2021-0080507 | A1 A A | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021199577 A
- JP 2022128100 A
- JP 2020047619 A

- JP 2006130691 A
- JP 2014147946 A
- JP 6678522 B